# EUROPEAN PATENT APPLICATION

(11) **EP 2 217 045 A1**
(43) Date of publication of application: **11.08.2010**
(21) Application number: 10162269.4
(22) Date of filing: 02.11.2007
(51) Int. Cl.: H05K 3/46, H05K 1/16

(54) **Wiring substrate and method of manufacturing the same**

(30) Priority: 18.10.2007 US 980969 P
(62) Divisional of application: 07831157.8
(71) Applicant: IBIDEN CO., LTD., Ogaki-shi, Gifu 503-8604 (JP)
(72) Inventor: Yoshikawa, Kazuhiro, Gifu 503-8604 (JP)
(74) Representative: HOFFMANN EITLE

(57) **Abstract**

The capacitors (350) are formed of the dielectric layer (330) and the first electrode (310) and the second electrode (320) mutually opposing with the dielectric layer (300) being sandwiched therebetween. The laminated capacitor (450) is such that the capacitors (350) are laminated via an adhesive (340). The wiring substrate (900) comprises the first resin insulating layer (200a) with the laminated capacitor (450) built-in, the first via conductors (411) electrically connecting the first electrodes (310) mutually, the second via conductors (412) electrically connecting the second electrodes (320) mutually, the first external terminals (427P) electrically connected to the first via conductors (411), and the second external terminals (427G) electrically connected to the second via conductors (412). The first electrodes (310) and the second electrodes (320) are disposed such that they are mutually offset in the direction of the electrode face.

## Description

### Technical Field

The present invention relates to a wiring substrate with a built-in capacitor and a method of manufacturing it.

### Background Art

With the demand for the miniaturization of electronic devices, there has been a call for the mounting efficiency of electronic components constituting electronic devices to be raised. To that end, to enhance the mounting efficiency, a wiring substrate having a built-in capacitor is disclosed in Patent Literature 1.

However, with the wiring substrate disclosed in this publication, it is difficult to secure both the capacitor built in the wiring substrate being of a high capacitance and the insulation resistance.

This is because the capacitor being of a high capacitance means the dielectric layer of the capacitor being thin and the dielectric layer being thin means a reduction in the insulation resistance of the capacitor. Alternately, the securing of the insulation resistance of a capacitor means the dielectric layer being thick which does not allow the capacitor to be of a large capacitance.

And, a wiring substrate with a plurality of capacitors built in formed such that dielectric layers and electrodes are alternately laminated is disclosed in Patent Literature 2. The wiring substrate disclosed in this publication is set forth such that the thickness of the dielectric layers is of a thickness necessary to obtain the insulation resistance of the capacitor and that the overall capacitance is made large with a plurality of capacitors disposed.

Naturally, with the wiring substrate disclosed in this publication, the presence of a defect in one capacitor means the presence of a defect in the laminated capacitor as a whole.

Patent Literature 1: Unexamined Japanese Patent Application KOKAI Publication No. 2005-191559.
Patent Literature 2: Unexamined Japanese Patent Application KOKAI Publication No. 2004-228190.

### Disclosure of Invention

### Problems to be Solved by the Invention

The present invention is made to solve the above-described problems and its object is to provide a wiring substrate with built-in capacitors having a high capacitance and the insulation resistance secured. And, another object is to secure the yield of a wiring substrate with a built-in laminated capacitor wherein capacitors are laminated and to provide a wiring board with built-in capacitors with a high capacitance and the insulation resistance secured. And, another object of the present invention is to provide a method of manufacturing such a wiring substrate.

### Means for Solving the Problem

To achieve the above-described objects, a wiring substrate relating to the first aspect in accordance with the present invention comprises:
a laminated capacitor formed by laminating capacitors via an adhesive, the capacitor being formed of a dielectric layer and the first electrode and the second electrode sandwiching the dielectric layer and mutually facing;
a first resin insulating layer with the laminated capacitor built-in;
first via conductors electrically connecting the first electrodes mutually;
second via conductors electrically connecting the second electrodes mutually;
first external terminals electrically connecting with the first via conductors; and
second eternal terminals electrically connecting with the second via conductors.

To achieve the above-described objects, a wiring substrate relating to the second aspect in accordance with the present invention comprises:
a plurality of resin insulating layers having at least the lowermost resin insulating layer and the uppermost resin insulating layer;
a plurality of conductor circuits formed in between the resin insulating layers;
a laminated capacitor embedded in one of the plurality of resin insulating layers and formed by laminating capacitors via an adhesive, the capacitor being formed of a dielectric layer and the first electrode and the second electrode sandwiching the dielectric layer and mutually facing;
first via conductors electrically mutually connecting the first electrodes;
second via conductors electrically mutually connecting the second electrodes;
first external connection terminals formed in the lowermost resin insulating layer and comprising the first external terminals electrically connecting with the first via conductors and the second external terminals electrically connecting with the second via conductors; and
second external connection terminals formed on the uppermost resin insulating layer and comprising the third external terminals electrically connecting with the first via conductors and the fourth external terminals electrically connecting with the second via conductors, wherein
the first external connection terminals are embedded in the lowermost resin insulating layer and concurrently the external terminal faces of the first external connection terminals being positioned on nearly the same plane as the first face of the lowermost resin insulating layer; and
the second external connection terminals are formed on the uppermost resin insulating layer.

And, to achieve the above-described objects, a method of manufacturing a wiring substrate relating to the third aspect in accordance with the present invention comprises:
a step of capacitor forming for forming capacitors having a dielectric layer and the first electrode and the second electrode mutually opposing with the dielectric layer being sandwiched therebetween;
a step of laminated-capacitor forming for forming a laminated capacitor by laminating the capacitors via an adhesive;
a step of laminating for laminating the first resin insulating layer on a base substrate;
a step of embedding for embedding the laminated capacitor in the first resin insulating layer;
a step of through-hole forming for forming in the laminated capacitor through holes penetrating the first electrodes and through holes penetrating the second electrodes;
a step of via-conductor forming for forming the first via conductors electrically mutually connecting the first electrodes and the second via conductors electronically mutually connecting the second electrodes by filling the through holes with metal conductors; and
a step of external-terminal forming for forming the first external terminals electrically connected to the first via conductors and the second external terminals electrically connected to the second via conductors.

And, to achieve the above-described objects, a method of manufacturing a wiring substrate relating to the fourth aspect in accordance with the present invention comprises:
a step of capacitor forming for forming capacitors having a dielectric layer and the first electrode and the second electrode sandwiching the dielectric layer and mutually facing;
a step of laminated-capacitor forming for forming a laminated capacitor by laminating the capacitors via an adhesive;
a step of the-first-extemal-connection-terminal forming for forming on a support board the first external connection terminals having the first external terminals and the second external terminals;
a step of building-up for alternately laminating on the first external connection terminals and on the support board a plurality of resin insulating layers and a plurality of conductor circuits;
a step of embedding for embedding the laminated capacitor in one resin insulating layer of the plurality of resin insulating layers;
a step of through-hole forming for forming through holes penetrating the first electrodes or the second electrodes in the laminated capacitor;
a step of via-conductor forming for forming the first via conductors electrically mutually connecting the first electrodes and the second via conductors electronically mutually connecting the second electrodes by filling the through holes with metal conductors;
a step of the second-external-connection-terminal forming for forming the second external connection terminals having the third external terminals and the fourth external terminals on the uppermost layer resin insulting layer positioned, of the plurality of resin insulating layers, on the opposite side from the support board; and
a step of support board removal for removing the support board,
wherein the first external terminals and the third external terminals are electrically connected to the first via conductors and the second external terminals and the fourth external terminals are electrically connected to the second via conductors.

### Effect of the Invention

According to the present invention, it is possible to obtain a wiring board with built-in capacitors with a high capacitance and the insulation resistance secured.

### Brief Description of Drawings

FIG. 1 is a sectional view of a wiring substrate pertaining to the first embodiment in accordance with the present invention.
FIG. 2A is a view describing a step of manufacturing a wiring substrate relating to the embodiment 1 whereby the first electrode, the dielectric layer, and the second electrode are laminated.
FIG. 2B is a view describing a step of manufacturing a wiring substrate pertaining to the embodiment 1 whereby the first electrode and the second electrode are positioned offset from each other.
FIG. 2C is a view describing a step of manufacturing a wiring substrate pertaining to the embodiment 1 whereby a laminated capacitor is formed such that capacitors are laminated.
FIG. 2D is a view describing a step of manufacturing a wiring substrate pertaining to the embodiment 1 illustrating a laminated capacitor wherein capacitors are laminated with an adhesive interposed.
FIG. 2E is a view describing a step of manufacturing a wiring substrate pertaining to the embodiment 1 whereby a resin insulating layer is laminated on a base substrate.
FIG. 2F is a view describing a step of manufacturing a wiring substrate pertaining to the embodiment 1 whereby a laminated capacitor is embedded in a resin insulating layer.
FIG. 2G is a view describing a step of manufacturing a wiring substrate pertaining to the embodiment 1 illustrating the resin insulating layer in which a laminated capacitor is embedded.
FIG. 2H is a view describing a step of manufacturing a wiring substrate pertaining to the embodiment 1 whereby a laminated capacitor is laminated onto a resin insulating layer.
FIG. 2I is a view describing a step of manufacturing a wiring substrate pertaining to the embodiment 1 whereby the second resin insulating layer is laminated onto the resin insulating layer.
FIG. 2J is a view describing a step of manufacturing a wiring substrate pertaining to the embodiment i whereby through holes are provided for via conductors in the laminated capacitor.
FIG. 2K is a view describing from the upper face the laminated capacitor of the wiring substrate pertaining to the first embodiment.
FIG. 2L is a view describing from the upper face the laminated capacitor of the wiring substrate pertaining to the first embodiment.
FIG. 2M is a view describing a step of manufacturing a wiring substrate pertaining to the embodiment 1 whereby conductor patterns are provided on the second resin insulating layer.
FIG. 2N is a view describing a step of manufacturing a wiring substrate pertaining to the embodiment 1 whereby the third resin insulating layer is further laminated.
FIG. 2O is a view describing a step of manufacturing a wiring substrate pertaining to the embodiment 1 whereby conductor patterns are provided on the third resin insulating layer.
FIG. 2P is a view describing a step of manufacturing a wiring substrate pertaining to the embodiment 1 whereby a plurality of opening portions are provided in a solder resist.
FIG. 2Q is a view describing a step of manufacturing a wiring substrate pertaining to the embodiment 1 whereby an IC chip is mounted via solder bumps.
FIG. 2R is a view describing a step of manufacturing a wiring substrate pertaining to the embodiment 1 whereby a resin layer is provided also on the lower face of the base substrate.
FIG. 3 is a sectional view of a wiring substrate pertaining to the second embodiment in accordance with the present invention.
FIG. 4A is a view describing a step of manufacturing a wiring substrate pertaining to the embodiment 2 whereby through holes for via conductors are provided in the laminated capacitor.
FIG. 4B is a view describing a step of manufacturing a wiring substrate pertaining to the embodiment 2 whereby conductor patterns are provided on the upper faces of the laminated capacitor and of the resin insulating layer.
FIG. 4C is a view describing a step of manufacturing a wiring substrate pertaining to the embodiment 2 whereby the second resin insulating layer is further provided.
FIG. 4D is a view describing a step of manufacturing a wiring substrate pertaining to the embodiment 2 whereby a resin layer is provided also on the lower face of the base substrate.
FIG. 5 is a sectional view of a wiring substrate pertaining to the embodiment 3 illustrating a laminated capacitor wherein via conductors are formed in the opening portions of the first electrodes and the second electrodes.
FIG. 6A is a view describing via conductors running in a grid pattern through the laminated capacitor of the wiring substrate pertaining to the embodiment 3.
FIG. 6B is a view describing via conductors running in a lattice pattern through the laminated capacitor of the wiring substrate pertaining to the embodiment 3.
FIG. 7A is a view describing a discrete capacitor of the wiring substrate pertaining to the embodiment 3 wherein the first electrode, a dielectric layer, and the second electrode are laminated.
FIG. 7B is a view describing a discrete capacitor of the wiring substrate pertaining to the embodiment 3 wherein the first electrode and the second electrode are patterned.
FIG. 7C is a plan view describing from the first electrode side the patterned capacitor of the wiring substrate pertaining to the embodiment 3.
FIG. 7D is a plan view describing from the second electrode side the patterned capacitor of the wiring substrate pertaining to the embodiment 3.
FIG. 7E is a view describing a step of manufacturing a wiring substrate pertaining to the embodiment 3 whereby a laminated capacitor is formed such that patterned capacitors are laminated.
FIG. 7F is a view describing a step of manufacturing a wiring substrate pertaining to the embodiment 3 and illustrating a laminated capacitor wherein patterned capacitors are laminated with an adhesive interposed.
FIG. 7G is a view describing a step of manufacturing a wiring substrate pertaining to the embodiment 3 whereby a laminated capacitor wherein patterned capacitors are laminated is embedded in a resin insulating layer.
FIG. 7H is a view describing a step of manufacturing a wiring substrate pertaining to the embodiment 3 whereby through holes are provided in the laminated capacitor wherein patterned capacitors are laminated.
FIG. 7I is a view describing a step of manufacturing a wiring substrate pertaining to the embodiment 3 whereby via conductors and conductor patterns are provided in and on the laminated capacitor wherein patterned capacitors are laminated.
FIG. 8 is a sectional view of a wiring substrate pertaining to the fourth embodiment in accordance with the present invention.
FIG. 9A is a view describing a support board supporting the resin insulating layer as pertained to the manufacturing step of a wiring substrate pertaining to the embodiment 4.
FIG. 9B is a view describing a step of forming a plating resist on the support board as pertained to the manufacturing step of a wiring substrate pertaining to the embodiment 4.
FIG. 9C is a view describing a step of forming a plurality of opening portions in the plating resist formed on the support board as pertained to the manufacturing step of a wiring substrate pertaining to the embodiment 4.
FIG. 9D is a view describing a step of manufacturing a wiring substrate pertaining to the embodiment 4 whereby external terminals are formed in the opening portions of the plating resist.
FIG. 9E is a view describing a step of manufacturing a wiring substrate pertaining to the embodiment 4 whereby the first resin insulating layer is formed on the support board.
FIG. 9F is a view describing a step of manufacturing a wiring substrate pertaining to the embodiment 4 whereby through holes are formed in the first resin insulating layer formed on the support board.
FIG. 9G is a view describing a step of manufacturing a wiring substrate pertaining to the embodiment 4 whereby conductor patterns are formed on the upper face of the first resin insulating layer.
FIG. 9H is a view describing a step of manufacturing a wiring substrate pertaining to the embodiment 4 whereby the second resin insulting layer is formed on the first resin insulating layer.
FIG. 9I is a view describing a step of manufacturing a wiring substrate pertaining to the embodiment 4 whereby a laminated capacitor is to be embedded in the second resin insulating layer.
FIG. 9J is a view describing a step of manufacturing a wiring substrate pertaining to the embodiment 4, describing the second resin insulating layer in which the laminated capacitor is embedded.
FIG. 9K is a view describing a step of manufacturing a wiring substrate pertaining to the embodiment 4 whereby through holes are provided in the second resin insulating layer with the laminated capacitor being embedded therein.
FIG. 9L is a view describing a step of manufacturing a wiring substrate pertaining to the embodiment 4 whereby via conductors and conductor patterns are provided in and on the second resin insulting layer.
FIG. 9M is a view describing a step of manufacturing a wiring substrate pertaining to the embodiment 4 whereby the third resin insulting layer is provided on the second resin insulting layer.
FIG. 9N is a view describing a step of manufacturing a wiring substrate pertaining to the embodiment 4 whereby through holes are provided in the third resin insulating layer.
FIG. 9O is a view describing a step of manufacturing a wiring substrate pertaining to the embodiment 4 whereby via conductors and conductor patterns are provided in and on the third resin insulting layer.
FIG. 9P is a view describing a step of manufacturing a wiring substrate pertaining to the embodiment 4 whereby a solder resist is provided on the third resin insulting layer.
FIG. 9Q is a view describing a step of manufacturing a wiring substrate pertaining to the embodiment 4 whereby external terminals are provided in a plurality of opening portions provided in the soldier resist.
FIG. 9R is a view describing a step of manufacturing a wiring substrate pertaining to the embodiment 4 whereby the support board is removed by etching.
FIG. 10 is a view illustrating a modified example of the wiring substrate pertaining to the embodiment 4 in accordance with the present invention.
FIG. 11 is a sectional view of a wiring substrate pertaining to the embodiment 5 wherein a laminated capacitor is embedded also in the resin insulating layer provided below the base substrate.

### Description of the Reference Numerals

- 100: Base substrate
- 200: Resin insulating layer
- 310: First electrode
- 320: Second electrode
- 330: Dielectric layer
- 340: Adhesive
- 350: Capacitor
- 411: Via conductor
- 412: Via conductor
- 413: Via conductor
- 414: Via conductor
- 421: Conductor pattern
- 423: Conductor pattern
- 425: Conductor pattern
- 450: Laminated capacitor
- 710: Alignment mark
- 720: Alignment mark
- 730: Alignment mark
- 900: Wiring substrate pertaining to the present invention

### Best Mode for Carrying Out the Invention

### (First embodiment of the wiring substrate in accordance with a specific mode of the present invention)

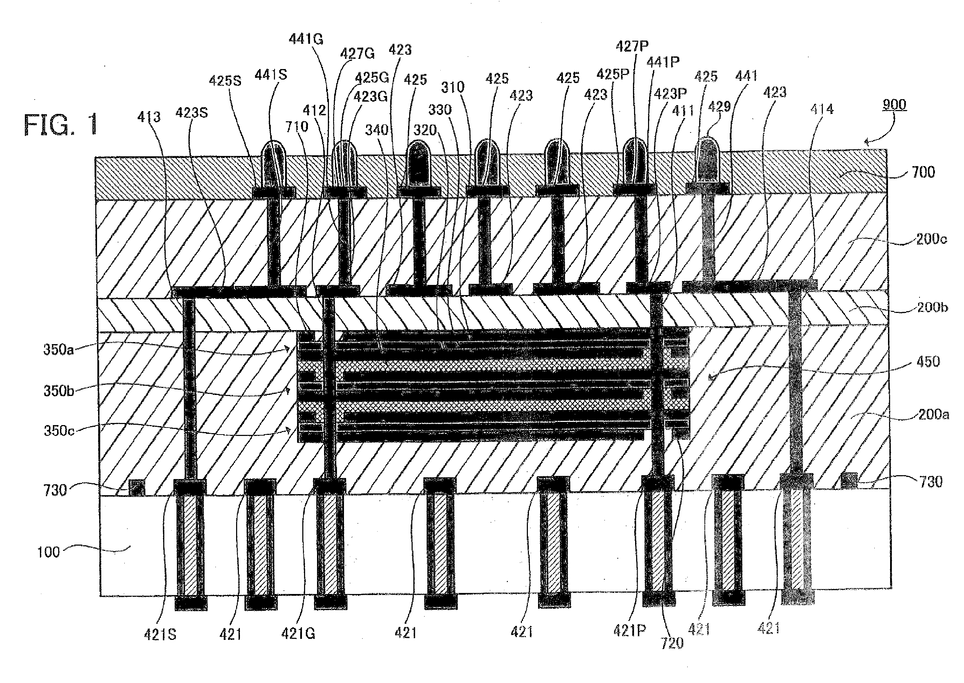

In the following, an embodiment of the present invention will be described with reference to the drawings.
As illustrated in FIG. 1, the wiring substrate 900 relating to the present embodiment has the first resin insulating layer 200a, the base substrate 100 supporting the first resin insulating layer 200a, and the laminated capacitor 450 embedded in the first resin insulating layer 200a.

On the first resin insulting layer 200a there is provided the second resin insulating layer 200b. On the second resin insulating layer 200b there is provided the third resin insulating layer 200c.

The upper face of the laminated capacitor 450 is at the upper face of the first resin insulating layer 200a, and the upper face of the laminated capacitor 450 and the upper face of the first resin insulating layer 200a are such that they sit flush with each other.

The laminated capacitor 450 is such that the capacitors 350a, 350b, and 350c are laminated via the adhesive 340. The adhesive 340 is an insulating resin being, for example, an epoxy resin.

The thickness of the laminated capacitor 450 is 30 µm to 100 µm, for example. It is because there is a possibility that the thickness being greater than 100 µm makes it difficult for the laminated capacitor 450 to be embedded in the first resin insulating layer 200a and alternately the thickness being less than 30 µm makes the structure to be too fine such that it could possibly impede the production efficiency of the wiring substrate.

Each of the capacitors 350a, 350b, and 350c has the dielectric layer 330 and the plate-shaped first electrode 310 and the second electrode 320. The first electrode 310 and the second electrode 320 are formed of rectangular plate-shaped conductors that are identical in size. The first electrode 310 and the second electrode 320 are offset from each other by a predetermined distance in the direction of the plane of the electrodes, and partially overlapped. The first electrode 310 and the second electrode 320 are, for example, 0.2 mm to 8 mm in length, 0.1 mm to 8 mm in width, and 3 µm to 15 µm in thickness. The first electrode 310 and the second electrode 320 are formed of copper.

The dielectric layer 330 is 0.5 µm to 10 µm in thickness, for example. It is because there is a possibility that the thickness of the dielectric layer 330 being less than 0.5 µm results in a poor insulation resistance of the capacitor, and, alternately, it is because there is a possibility that that of greater than 10 µm does not provide a value that would satisfy the capacitor to be of a large capacitance.

The distance between the capacitors 350, the distance between the second electrode 320 of the capacitor 350a and the first electrode 310 of the capacitor 350b (i.e., the thickness of the adhesive layer formed by the adhesive 340), for example, is 2 µm to 12 µm, for example. When it is less than 2 µm, it results in the amount of the adhesive 340 to be filled between the capacitors 350 being insufficient leading to a possibility of the adhesion between the capacitors being weak. And, the thickness of the adhesive 340 being thin could possibly lead to a low insulation resistance between the capacitors (between 350a and 350b and between 350b and 350c). Alternately, it is because there is a possibility that when it is greater than 12 µm, an increase in the thickness of the laminated capacitor 450 could impede the fine wiring structure of the wiring substrate 900.

The dielectric layer 330 is a ceramic dielectric layer. The dielectric layer 330 is formed of, for example, barium titanate (BaTiO₃). A thermoplastic resin or thermosetting resin containing a dielectric filler may be used for the dielectric layer 330. For a thermoplastic resin, polyester may be used, and for a thermosetting resin, a phenol resin may be used. A dielectric filler is formed of strontium titanate (SrTiO₃), for example.

The via conductors 411 electrically connect the respective first electrodes 310 mutually of the capacitors 350a, 350b, and 350c. And, the via conductors 412 electrically connect the respective second electrodes 320 mutually of the capacitors 350a, 350b, and 350c.

On the base substrate 100 there are provided a plurality of conductor patters (conductor circuits) 421 (421P, 421G, 421S), and on the second resin insulating layer 200b there are provided a plurality of conductor patterns 423 (423P, 423G, 423S). On the third resin insulating layer 200c there are provided a plurality of conductor patterns 425 (425P, 425G, 425S).

And, the via conductors 411 electrically connect the conductor patterns 421P and the conductor patterns 423P. The via conductors 412 electrically connect the conductor patterns 421G and the conductor patters 423G. The conductor patterns 423G connected to the via conductors 412 are connected to the ground line, and the conductor patterns 423P connected to the via conductors 411 are connected to the power supply line. The via conductors 441P electrically connect the conductor patterns 423P and the conductor patterns 425P. The via conductors 441G electrically connects the conductor patterns 423G and the conductor patterns 425G.

The base substrate 100 is 200 µm to 800 µm in thickness. The base substrate 100 is formed of glass epoxy resin, for example. A glass epoxy resin is an epoxy resin with a glass filler added thereto which is impregnated into a glass cloth (glass epoxy substrate).

The first resin insulating layer 200a, the second resin insulting layer 200b, and the third resin insulating layer 200c are 40 µm to 120 µm in thickness, for example. The resin insulating layers 200a, 200b, and 200c are made of a thermosetting resin such as an epoxy resin, for example. Resin insulating layers 200a, 200b and 200c may be of inorganic particulates such as glass, alumina, and barium carbonate and of a thermosetting resin. As to the glass epoxy substrate, it may be a glass epoxy substrate wherein two layers of glass cloths are overlapped.

The wiring substrate 900 is capable of performing various electrical signal processings such as transmitting electrical signals via the conductor patterns 421S, etc.

And, the wiring substrate 900 is, as the laminated capacitor 450 is provided in the first resin insulating layer 200a, capable of decouple the noise while reducing the space to be used.

And, as the capacitor can be formed near the IC chip to be mounted on the wiring substrate 900, the delay in the power supply to the IC can be prevented.

The laminated capacitor 450 built in the first resin insulating layer 200a is such that capacitors 350 are laminated. Accordingly, while the insulation resistance value of each of the capacitors 350 is maintained around constant by maintaining the thickness of the dielectric layer 330 of each of the capacitors 350 in a predetermined thickness and as a plurality of capacitors 350 are laminated, an increased capacitor capacitance as the laminated capacitor 450 as a whole can be achieved. Thus, a capacitor having both a large capacitance and a high insulating level can be achieved.

And, the capacitors 350 are formed of the plate-shaped first electrode 310, the second electrode 320 positioned offset in the direction of the face of the electrodes off the first electrode, and the dielectric layer 330. As such, as they are alternately formed offsetting the first electrode 310 and the second electrode 320 of each of the capacitors 350, there can easily be provided the via conductors 41 electrically connecting the first electrodes 310 mutually of each of the capacitors 350a, 350b, and 350c and the via conductors 412 electrically connect one second electrode 320 to another of the second electrode 320 of each of the capacitors 350a, 350b, and 350c. Thus, since the via conductors need not be formed in the areas where the first electrodes 310 and the second electrodes 320 are mutually opposing, the electrode areas can be made large, allowing the capacitors to be of a large capacitance to be achieved. Further, since the number of via conductors penetrating the capacitor electrodes can be small, the occurrence of cracks in the dielectric layers due to the thermal expansion of the via conductors can as best as possible be controlled.

Further, the laminated capacitor 450 is formed such that capacitors 350 are laminated. Accordingly, in forming the laminated capacitor 450, the insulation resistance value of each of the capacitors 350 is checked and only the capacitors 350 with a good insulation resistance are selected in advance for lamination. Thus, a non-defective item as the laminated capacitor 450 as a whole as well can be obtained to secure the insulation reliability of the laminated capacitor 450. Were a laminated capacitor to be formed such that an electrode and a dielectric layer were to be alternately laminated, it would be difficult to check in advance to see if the insulation resistance of each of the capacitor portions were good. Accordingly, it would be difficult to secure the insulation reliability of the laminated capacitor at the manufacturing stage.

And, the laminated capacitor 450 built in in the resin insulating layer 200a is such that the capacitors 350 are laminated with the adhesive 340 such as a resin interposed. It is also possible to use the materials with the thermal expansion coefficient of the resin used for the adhesive 340 and the thermal expansion coefficient of the resin insulating layer 200a having the same value, and, accordingly, the thermal expansion coefficient of the laminated capacitor 450 as a whole can be brought close to the thermal expansion coefficient of the resin insulating layer 200a. Thus, were the laminated capacitor 450 to heat up, the possibility of cracks occurring at the interlace between the resin insulating layer 200a and the laminated capacitor 450 is low. Thus, it is difficult for cracks to occur in the dielectric layer 330.

### (A Method of Manufacturing a Wiring Substrate Relating to the First Embodiment in Accordance with the Present Invention)

First, on the first electrode 310 made of copper being 5 µm in thickness a high dielectric material made of BaTiO₃ is printed in a thin film being 5 µm to 10 µm in thickness with the use of a printer such as a doctor blade to form a non-baked layer. To form a thinner dielectric layer (0.5 µm to 5 µm), the sol gel process, sputtering, etc., which will be described below may be used.

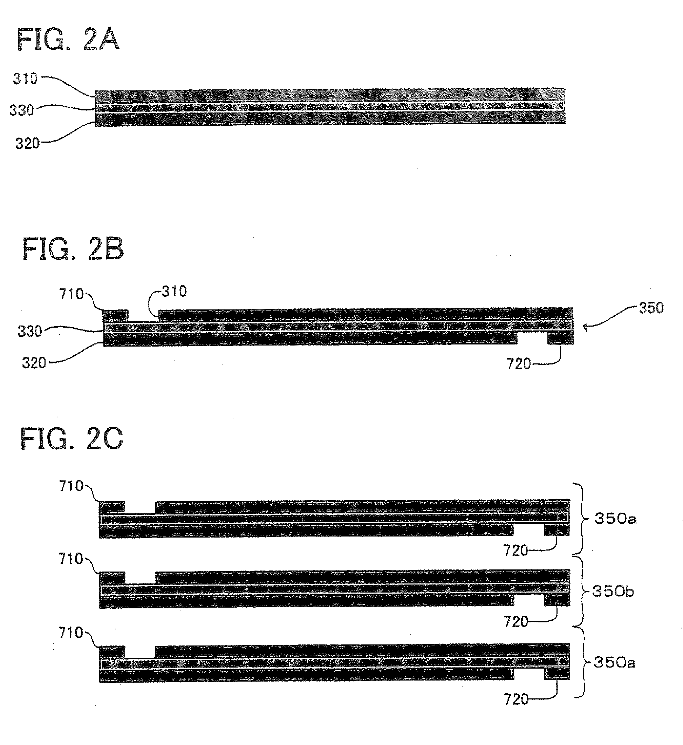

Next, the non-baked layer is baked in vacuum in a non-oxidizing atmosphere such as N₂ gas at the temperature range of 600 to 950°C to obtain the dielectric layer 330. Subsequently, a metal layer made of copper is formed on the dielectric layer 330 with the use of a vacuum evaporation apparatus such as sputtering and, further, on this metal layer copper is added by about 5 µm by electroplating, etc., to form the second electrode 320. As such, as illustrated in FIG. 2A, a capacitor wherein the dielectric layer 330 formed of BaTiO₃ is sandwiched by the first electrode 310 and the second electrode 320 formed of copper is obtained.

Next, as illustrated in FIG. 2B, the first electrode 310 and the second electrode 320 are formed such that they are offset in the direction of the face (i.e., the horizontal direction) by stripping the portions of the first electrode 310 and the second electrode 320 other than those needed by the etching processing with the use of cupric chloride etching solution to provide the discrete capacitors 350. In that case, the first electrode 310 and the second electrode 320 are offset in the horizontal direction such that the overlap of the first electrode 310 and the second electrode 320 present above and below the dielectric layer 330 is about 4 to 1.0 cm². And, by the etching processing, the alignment mark 710 is formed in the first electrode 310, and the alignment mark 720 is formed in the second electrode 320.

Next, as illustrated in FIG. 2C, three capacitors 350a, 350b, and 350c are laminated in the vertical direction. When the capacitors 350a, 350b, and 350c are laminated, an epoxy resin as an adhesive is interposed in between the capacitors 350. Among the discrete capacitors 350a, 350b, and 350c, they are aligned with the alignment mark 710 or alignment mark 720 provided in each of the capacitors as references.

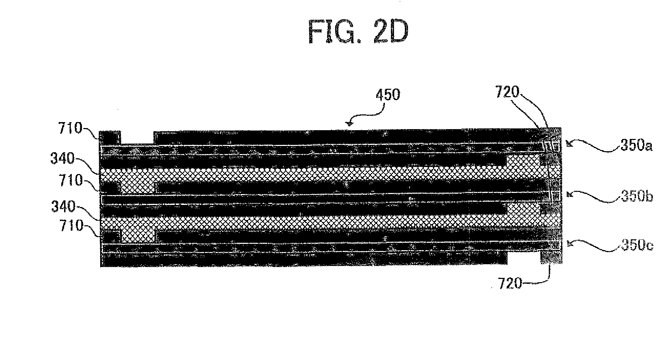

And, as illustrated in FIG. 2D, the laminated capacitor 450 is obtained such that three capacitors 350a, 350b, and 350c are with the adhesive 340 interposed in between the capacitors.

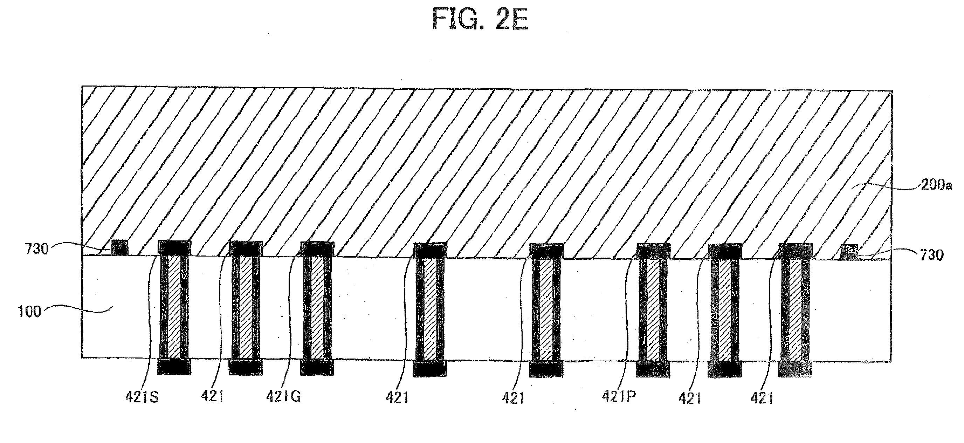

Next, as illustrated in FIG. 2E, on the base substrate (core substrate) 100 having the alignment mark 730 formed thereon, a thermosetting resin film is attached with the use of a vacuum laminator under the lamination conditions of the temperature being 50 through 170°C and the pressure being 0.4 through 1.5 MPa. On the base substrate 100 there are formed conductor patterns 421 (421P, 421G, 421S). The base substrate 100 is a glass epoxy substrate having a thickness of 0.6 mm. While the thermosetting resin film is semi-cured when it is attached, it becomes the first resin insulating layer (the lower resin insulating layer) 200a as it hardens. As for a resin film, two sheets of ABF-45SH made by Ajinomoto Co., Inc., can be used.

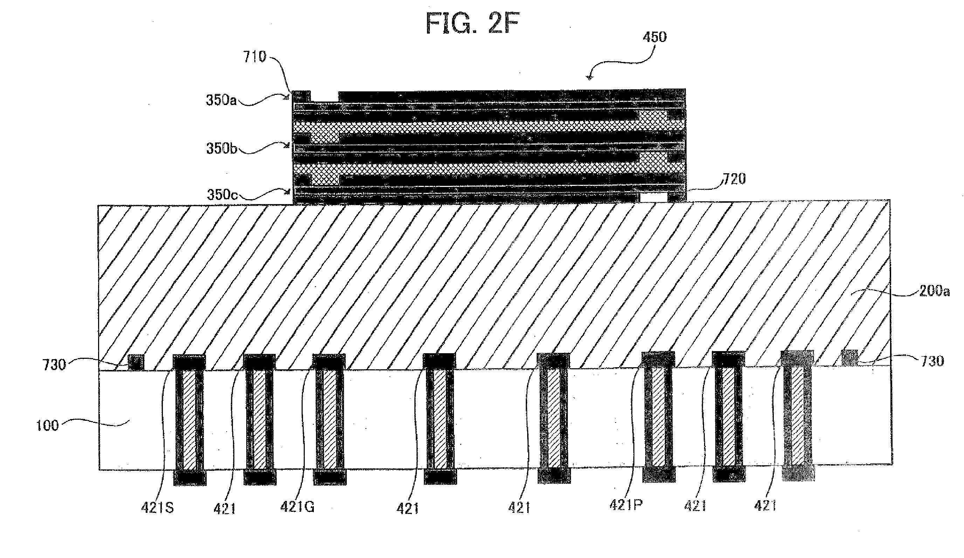

Next, as illustrated in FIG. 2F, the laminated capacitor 450 is aligned on the first resin insulating layer 200a which is semi-hardened and laminated. The alignment of the two is performed such that the alignment mark 710 present in the capacitor 350a from among the capacitors of the laminated capacitor 450 and the alignment mark 730 of the base substrate 100 are recognized by a camera. Or, it is performed such that the alignment mark 720 present in the capacitor 350c from among the capacitors of the laminated capacitor 450 and the alignment mark 730 in the base substrate 100 are recognized by a camera. It may be either that either one of the alignment mark 710 and the alignment mark 720 may be provided or that the both may be provided.

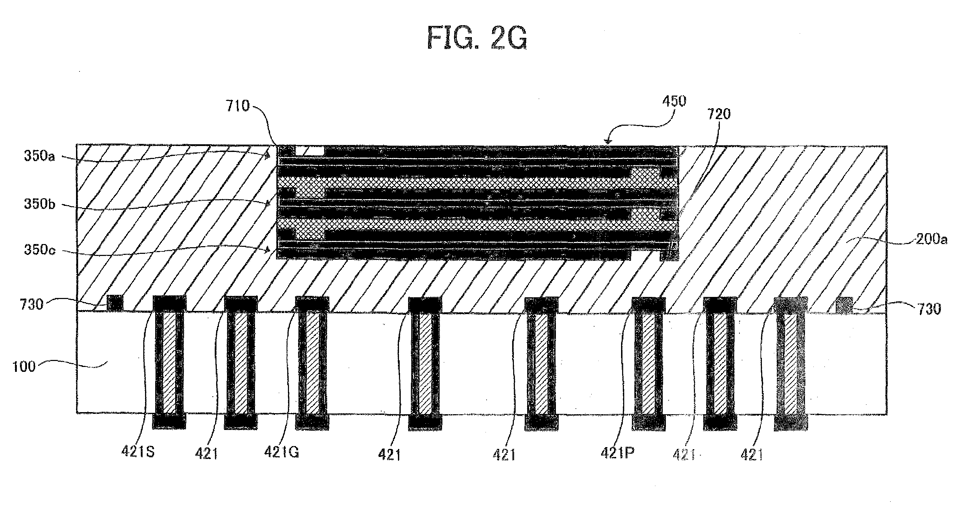

Subsequently, as illustrated in FIG. 2G, under the press conditions of 0.4 MPa, 170°C, and 2 hours, they are vacuum-pressed such that the laminated capacitor 450 is embedded into the resin insulting layer 200a and concurrently that the first resin insulating layer 200a is cured. The laminated capacitor 450 is embedded in the first resin insulating layer 200a such that the upper face of the laminated capacitor 450 and the upper face of the first resin insulating layer 200a sit flush with each other.

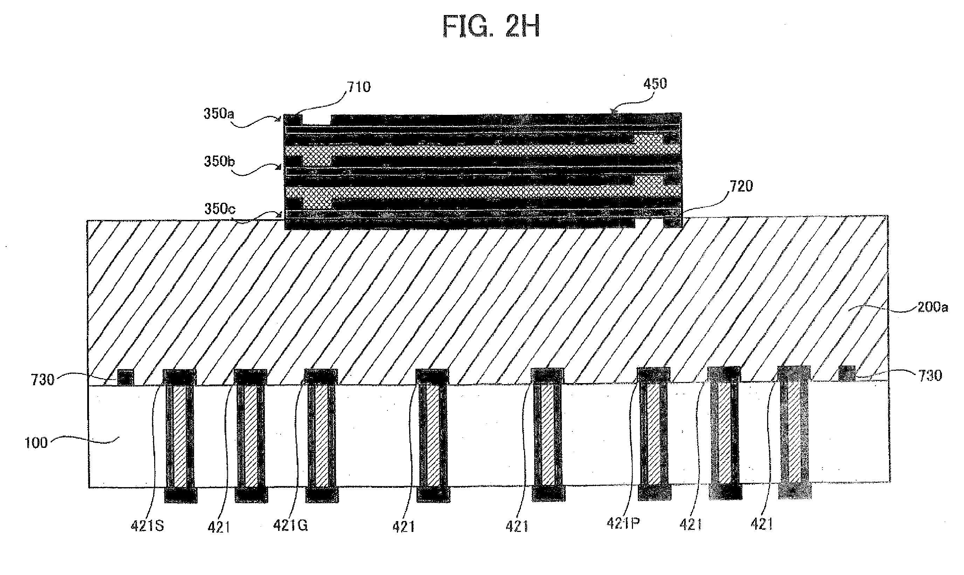

It is possibly for the laminated capacitor to be laminated on the first resin insulating layer 200a such, as illustrated in FIG. 2H, that a portion of the capacitor 350c is embedded. In such a case as well, the alignment mark 720 provided on the capacitor 350c or the alignment mark 710 provided in the capacitor 350a of the laminated capacitor 450 and the alignment mark 730 provided on the base substrate 100 are the reference marks for aligning the laminated capacitor 450 and the first resin insulating layer 200a.

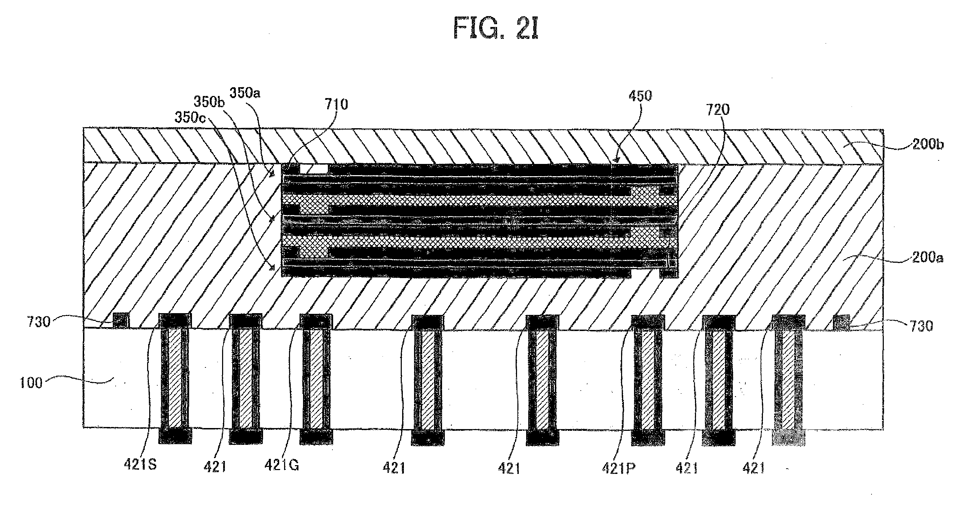

Next, as illustrated in FIG. 2I, on the first resin insulating layer 200a and on the laminated capacitor 450 a resin film is attached with the use of a vacuum laminator under the lamination conditions of the temperature being 50-170°C and the pressure being 0.4 to 1.5 MPa. As to the resin film, ABF-45SH made by Ajinomoto Co., Inc., for example, can be used. Subsequently, the resin film is thermally treated at 170°C for two hours such that it is cured to form the second resin insulating layer (the upper resin insulating layer) 200b.

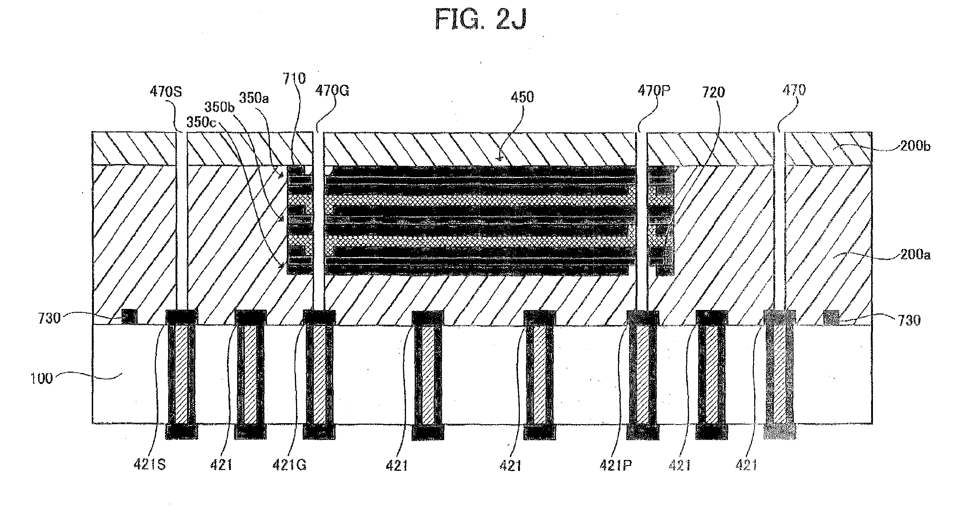

Next, as illustrated in FIG. 2J, with a carbon dioxide gas laser the through holes 470 (470P, 470G, 470S) are provided penetrating the second resin insulating layer 200b, the first resin insulating layer 200a, and the laminated capacitor 450 and reaching the conductor patterns 421 (the conductor patterns for power supply 421P, the conductor patterns for ground 421G, the conductor patterns for signal 421S) on the base substrate 100.

The through holes 470P are the through holes for power supply reaching the conductor patterns for power supply 421P. The through holes 470G are the through holes for ground reaching the conductor patterns for ground 421G. The diameters of the through holes 470 (470P, 470G, 470S) are 20 µm to 100 µm. It is possibly to provide the through holes 470 (470P, 470G, 470S) not with a carbon dioxide gas laser but with a drill. Here, the positions of the through holes 470 (470P, 470G, 470S) are determined by recognizing either of the alignment mark 730 of the base substrate 100, the alignment mark 710 of the capacitor 350a in the laminated capacitor 450, or the alignment mark 720 of the capacitor 350c in the laminated capacitor 450 with a camera or an X-ray.

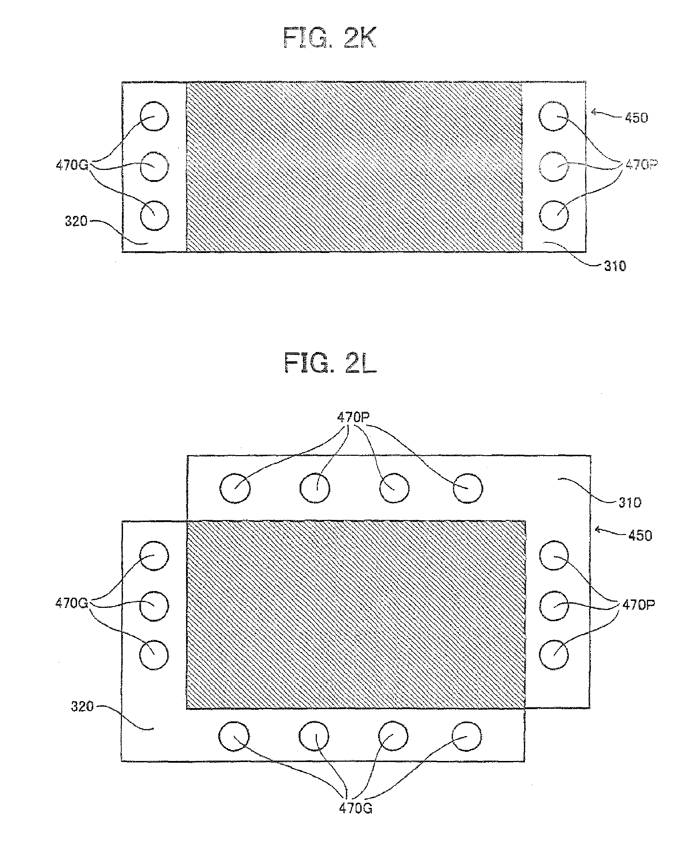

As illustrated in FIG. 2K and FIG. 2L being plan views, capacitors are formed with the portion where the first electrode 310 and the second electrode 320 overlap. As illustrated in FIG. 2K, it is possible for the first electrode 310 and the second electrode 320 to be offset only in the lateral direction, and, as illustrated in FIG. 2L, it is possible for the first electrode 310 and the second electrode 320 to be offset in the lateral direction and in the longitudinal direction. The portion where the first electrode 310 and the second electrode 320 overlap is illustrated by oblique lines. The first electrode 310 and the second electrode 320 are offset from each other in the direction of the face such that there are present portions where they do not overlap. In the portions where they do not overlap there are formed the through holes 470P and 470G. As such, since in the portion where the first electrode 310 and the second electrode 320 mutually oppose there are not formed the through holes 470P and 470G, the area where the first electrode 310 and the second electrode 320 mutually oppose can be made large. While the through holes for power supply 470P are in contact with the first electrode 310 (the electrode for power supply), they are not in contact with the second electrode 320 (the electrode for ground). While the through holes for ground 470G are in contact with the second electrode 320, they are not in contact with the first electrode 310.

As illustrated in FIG. 2J, besides the through holes 470P and 470G, there are formed the through holes for signal 470S reaching the conductor patterns for signal. The through holes for signal 470S are formed in the area where the laminated capacitor 450 is not present.

Next, a surface treatment is performed on the surface of the second resin insulating layer 200b by a catalyst.

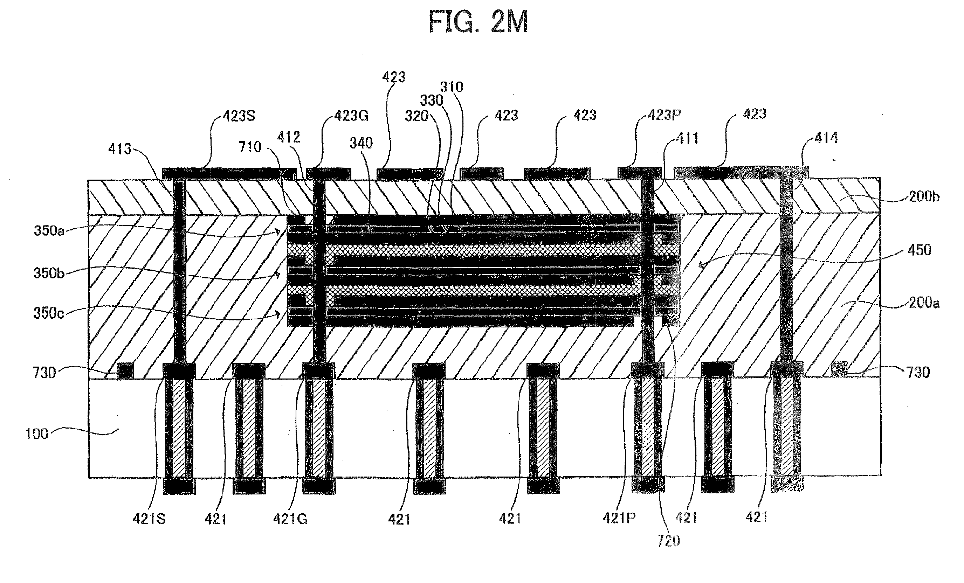

Next, there are formed electroless plated films (electroless copper-plated films) on the surface of the second resin insulating layer 200b and on the inside wall faces of the through holes (470P, 470G, 470S). Subsequently, on the electroless plated films there are formed electroplated films (electro-copper-plated films). Following that, an etching resist is formed on the electroplated films. Subsequently, through the exposure/development steps, the etching resist is patterned. The photolithography method whereby the portions where patterns are formed on a resin layer and the portions where the through-hole plating is protected are covered with resists is referred to as a renting process. And, by etch-removing the electroplated films and the electroless plated films on the portions where etching resists are not formed, as illustrated in FIG. 2M, the conductor patterns 423 (the conductor pattern for power supply 423P, the conductor pattern for ground 423G, the conductor pattern for signal 423S) and the via conductors 411, 412, 413 are formed.

The via conductors 411 are via conductors for power supply, electrically connecting, as illustrated in FIG. 2M, the first electrodes 310 mutually of the capacitor 350a, the capacitor 350b, and the capacitor 350c. And, the via conductors 412 are via conductors for ground, electrically connecting, as illustrated in FIG. 2M, one second electrode to another of the second electrodes 320 of the capacitor 350a, the capacitor 350b, and the capacitor 350c.

The via conductors for power supply 411 connect the conductor patterns for power supply 421P on the base substrate 100 and the conductor patterns for power supply 423P on the second resin insulating layer 200b. And, the via conductors for ground 412 connect the conductor patterns for ground 421G on the base substrate 100 and the conductor patterns for ground 423G on the second resin insulating layer 200b.

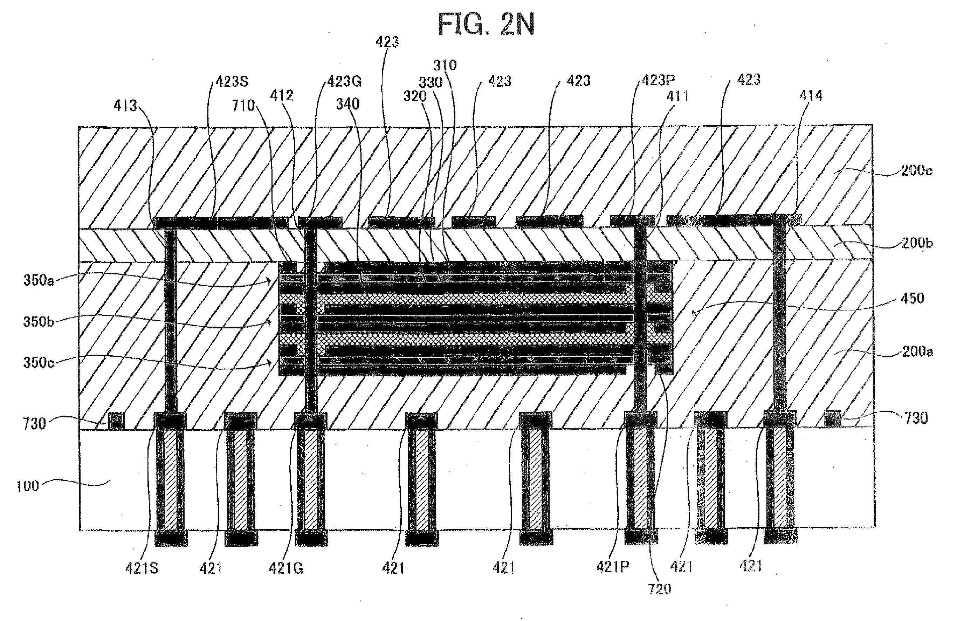

Next, as illustrated in FIG. 2N, on the second resin insulting layer 200b and the conductor patterns 423 (423P, 423G, 423S) there is formed the third resin insulating layer 200c. The material for the third resin insulating layer 200c is the same as those of the second resin insulating layer 200b and the first resin insulating layer 200a.

Next, in the third resin insulating layer 200c there are formed through holes with a carbon dioxide gas laser. It is possible to form through holes with a drill.

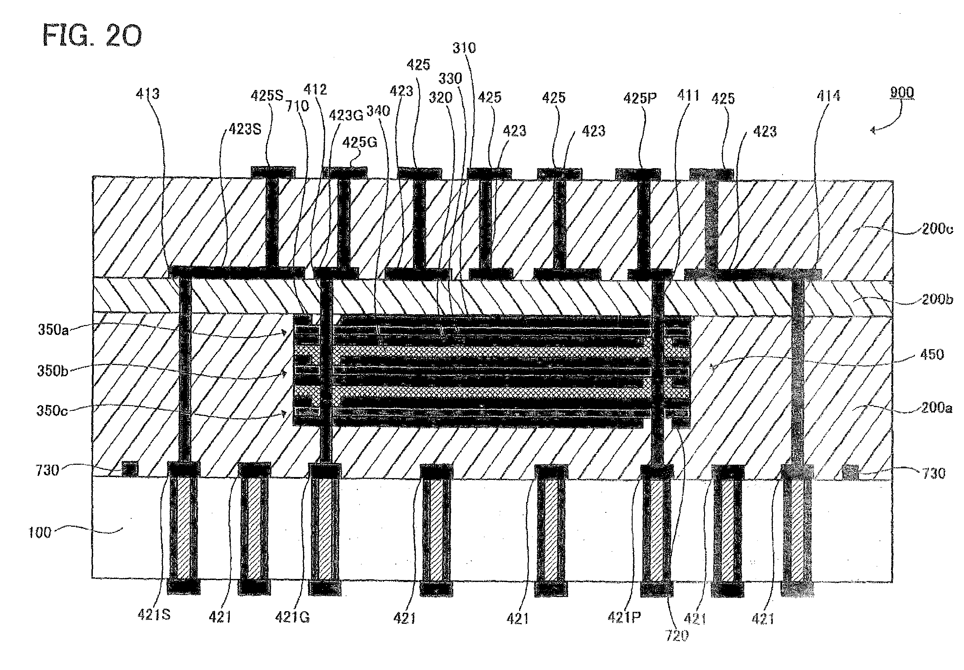

Next, a surface treatment is performed on the surface of the third resin insulating layer 200c by a catalyst. Following the surface treatment by a catalyst, an electroless plated film is formed on the surface of the substrate. Subsequently, a plated resist is formed on the electroless plated film. Following that, the plated resist is treated with exposure and development to pattern the plated resist. And, on the areas where the plated resist is not formed there are formed electro-plated films. After the plated resist is stripped, there are provided, as illustrated in FIG. 2O, the outermost conductor patterns 425 (the outermost conductor patterns for power supply 425P, the outermost conductor patterns for ground 425G, the outermost conductor patterns for signal 425S) made of electroless plated film and electro-plated film provided on said electroless plated film by removing the electroless plated film between the electroplated films.

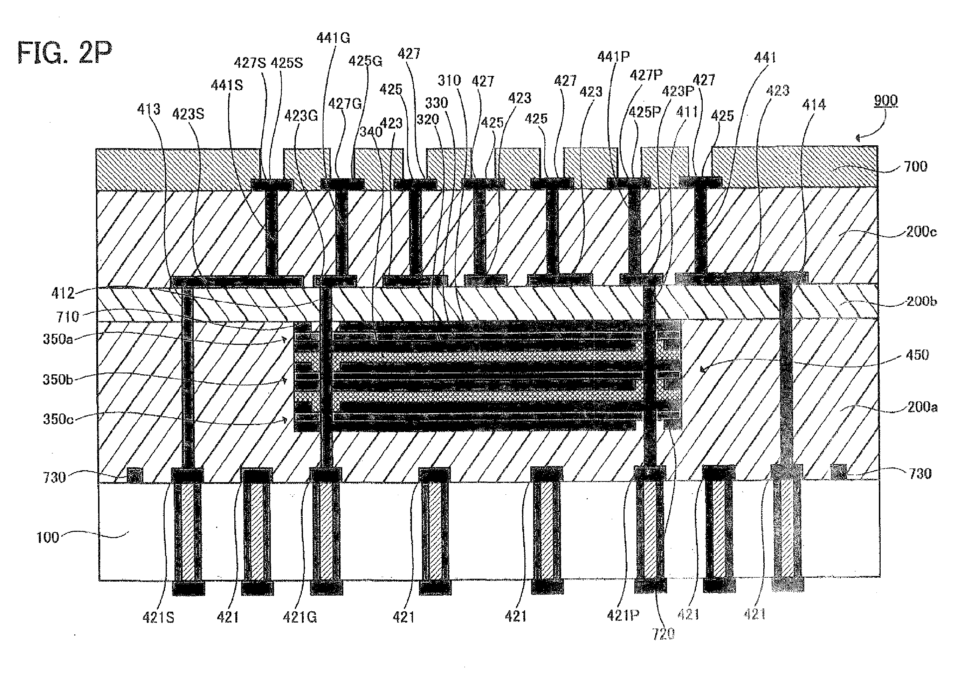

Next, on the third resin insulating layer 200c and the outermost conductor patterns 425 (425P, 425G, 425S) there is formed a solder resist. Subsequently, as illustrated in FIG. 2P, opening portions are provided in the solder resist 700 to expose portions of the conductor patterns 425 (425P, 425G, 425S) such that the pads 427 (the pads for power supply (the first eternal terminals) 427P, the pads for ground (the second external terminals) 427G, the pads for signal 427S) are formed. The portions exposed from the opening portions constitute the pads 427 (427P, 427G, 427S).

As illustrated in FIG. 2P, the first electrodes 310 and the pads for power supply 427P are connected via the via conductors 411, the conductor patterns 423P, and the via conductors 441P. And, the second electrodes 320 and the pads for ground 427G are connected via the via conductors 412, the conductor patterns 423G, and the via conductors 441G.

Next, on the pads 427 (427P, 427G, 427S), there were formed anti-corrosive metal films. As metal films, films made of Ni, Au, Pd, Ag, Pt, etc., for example, can be formed. In the present embodiment, Ni film, Pd film, and Au film are formed in that order. The metal films may be of one layer or of a plurality of metal films. To illustrate, Ni film and Au film can be formed on the pads in that order.

Next, on the metal films solder paste is printed. Subsequently, it is reflowed to provide the solder bumps 429 such that the wiring substrate 900 illustrated in FIG. 1 is obtained.

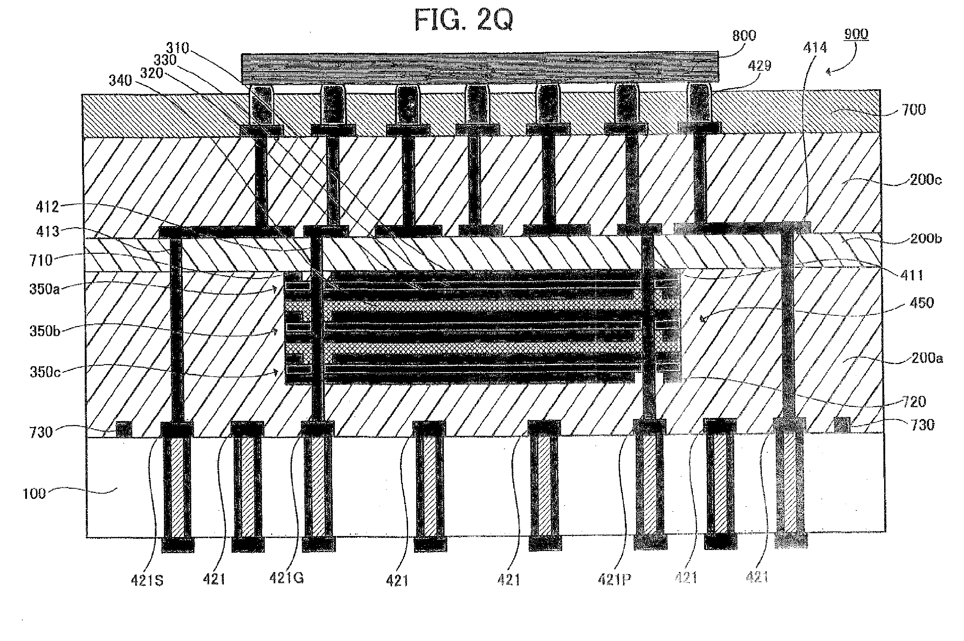

And, when mounting the IC chip 800, the IC chip 800 is mounted via the solder bumps 429, as illustrated in FIG. 2Q.

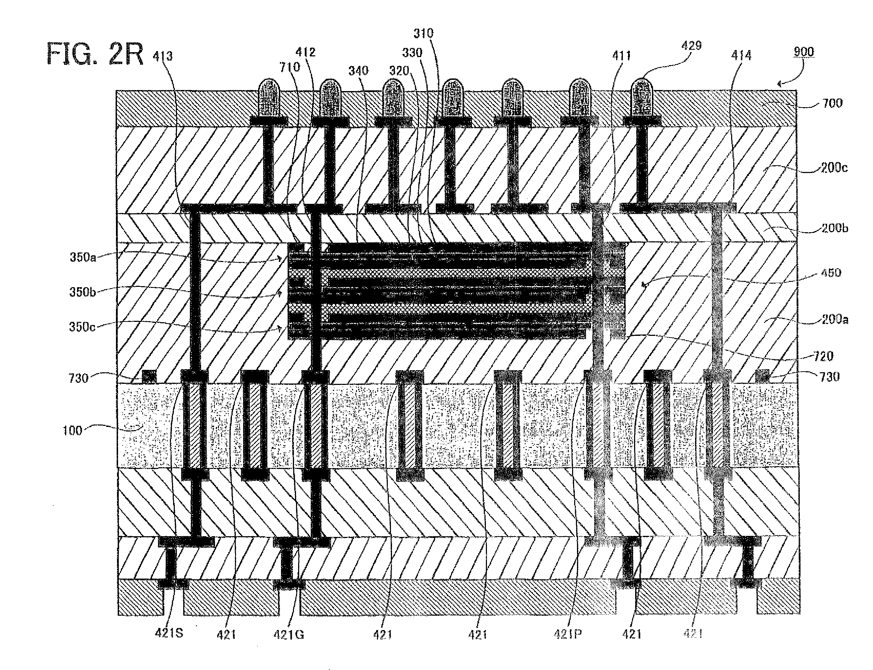

While in accordance with the present embodiment, the resin insulating layers, conductors patterns, and the via conductors are formed on only one face of the base substrate 100, it is possible to form the resin insulating layers, the conductor patterns, and the via conductors on both faces of the base substrate 100, as illustrated in FIG. 2R.

And, it is preferred that the surfaces of the resin insulting layers 200a, 200b, 200c, the surfaces of the conductor patterns 421, 423, 425, the surfaces of the first electrodes 310, and the surfaces of the second electrodes 320 are roughened. And, when the IC chip 800 is mounted on the surface of the wiring substrate 900, it is preferred that the distance between the laminated capacitor 450 and the IC chip 800 is short.

### (Second embodiment of the wiring substrate in accordance with a specific mode of the present invention)

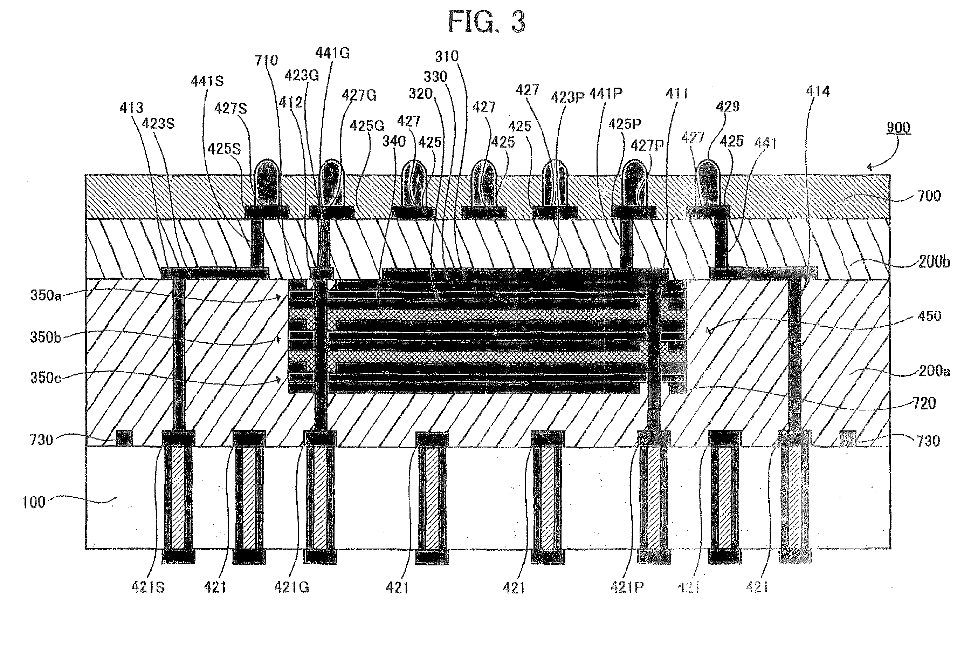

In the first embodiment, the resin insulating layers 200 consisted of the first resin insulating layer 200a, the second resin insulating layer 200b, and the third resin insulating layer 200c. The wiring substrate 900 relating to the second embodiment differs from that of the first embodiment as illustrated in FIG. 3 such that the resin insulating layers 200 consist of the first resin insulating layer 200a and the second resin insulating layer 200b.

And, the electrode positioned at the uppermost layer of the laminated capacitor 450 is formed such that the first electrode 310 of the capacitor 350a and the conductor patterns for power supply 423P on said first electrode 310 are integrated. Accordingly, in the wiring substrate 900 relating to the second embodiment, the thickness of the electrode present on the surface layer of the laminated capacitor 450 is thicker than the wiring substrate 900 relating to the first embodiment. Accordingly, the rigidity of the laminated capacitor 450 is enhanced. Thus, the dielectric layer of the laminated capacitor 450 is less susceptible to the occurrence of cracks.

As illustrated in FIG. 3, the pads for power supply (the first external terminals) 427P and the first electrode 310 of each of the capacitors 350a, 350b, and 350c are electrically connected via the via conductors 441P, the conductor patterns 423P, and the via conductors 411. The pads for ground (the second external terminals) 427G and the second electrode 320 of each of the capacitors 350a, 350b, and 350c are electrically connected via the via conductors 441G, the conductor patterns 423G, and the via conductors 412.

On the second resin insulating layer 200b there are provided the outermost conductor patterns for power supply 425P, the outermost conductor patterns for ground 425G, and the outermost conductor patterns for signal 425S.

Opening portions are provided in the solder resist 700 to expose portions of the conductor patterns 425 (425P, 425G, 425S) such that the pads 427 (the pads for power supply (the first external terminals) 427P, the pads for ground (the second external terminals) 427G, the pads for signal 427S) are formed.

### (A Method of Manufacturing a Wiring Substrate Relating to the Second Embodiment in Accordance with the Present Invention)

Next, another method of manufacturing a wiring substrate relating to the second embodiment will be illustrated.
First, it is the same as the above-described method of manufacturing a wiring substrate as to FIG. 2A through FIG. 2G.

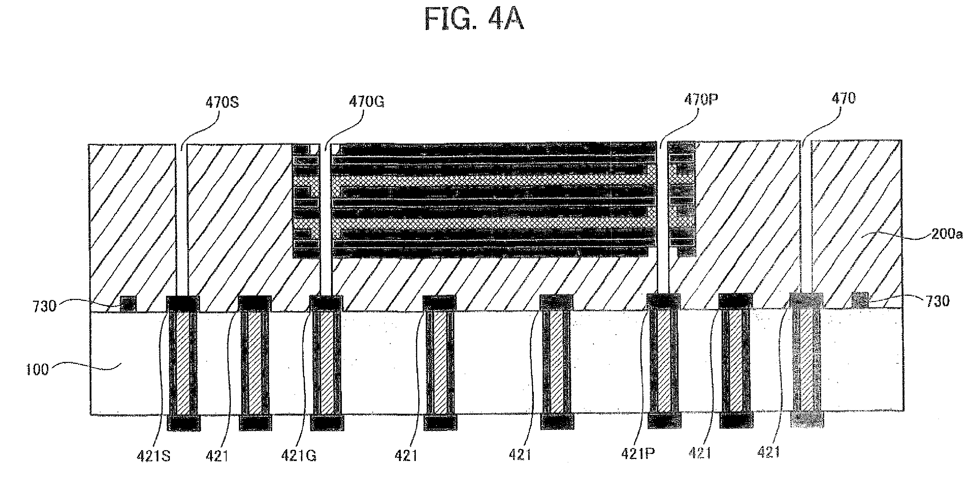

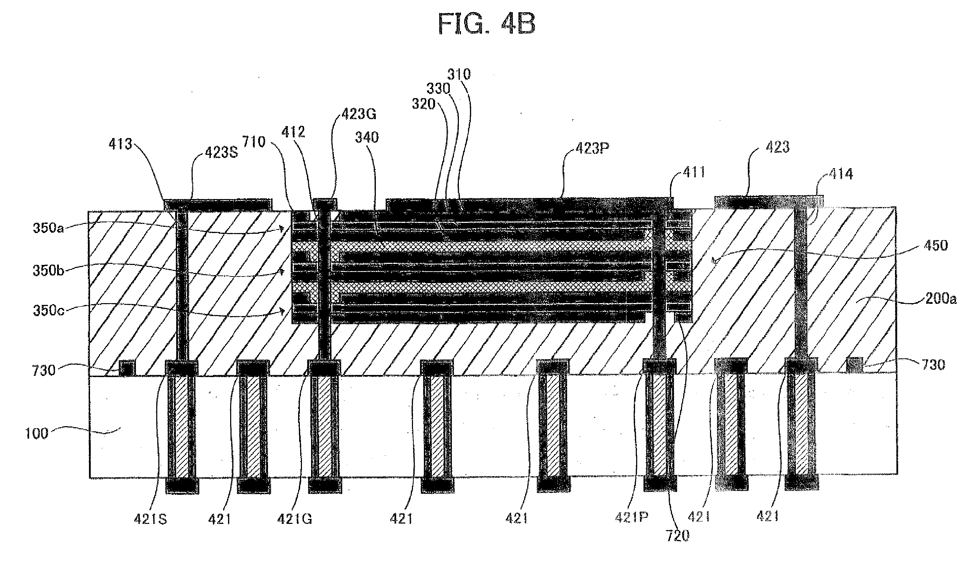

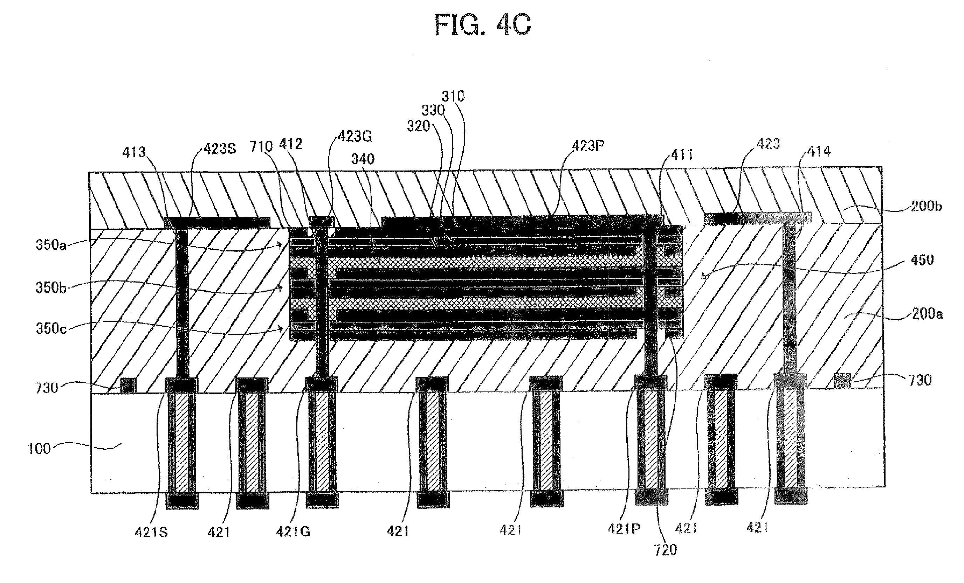

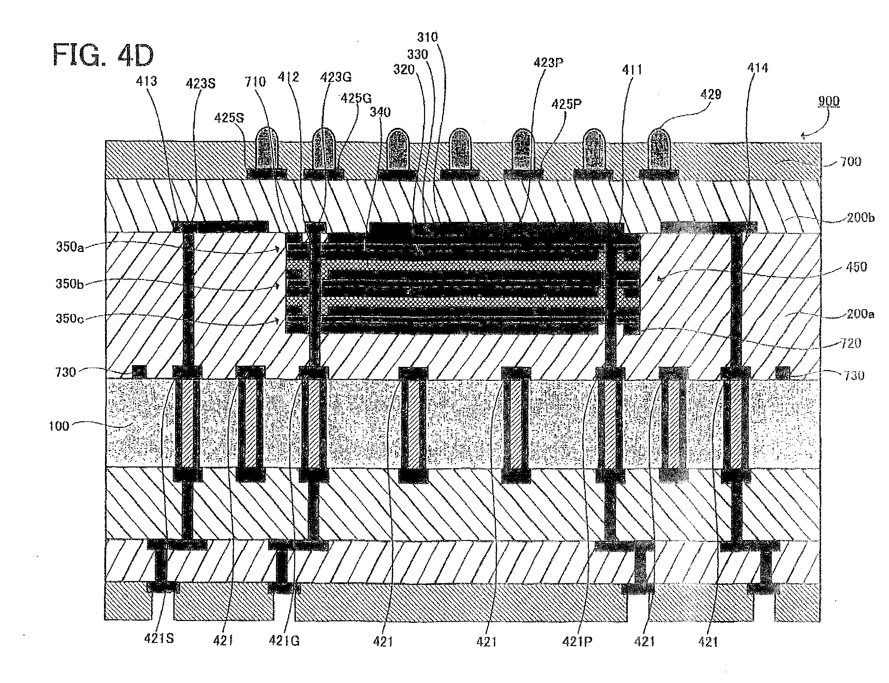

Next, as shown in FIG. 4, in the substrate prepared by the steps up to FIG. 2G there are formed the through holes 470 (the through holes 470P reaching the conductor patterns for power supply on the core substrate, the through holes 470G reaching the conductor patterns for ground on the core substrate, the through holes 470S reaching the conductor patterns for signal on the core substrate). While in the manufacturing method relating to the first embodiment, through holes were concurrently formed in the second resin insulating layer 200b as well, since in the manufacturing method relating to the present embodiment, it is only that through holes are formed penetrating the laminated capacitor 450 and the first resin insulating layer 200a, it results in an easy hole processing and an improved yield. And, a surface treatment is performed by a catalyst on the surface of the first resin insulating layer 200a in which the through holes 470 are formed.

Next, as illustrated in FIG. 4B, the via conductors for ground 412, the via conductors for power supply 411, the via conductors for signal 413, and the conductor patterns 423 (the conductor patterns for power supply 423P, the conductor patterns for ground 423G, the conductor patterns for signal 423S) are formed with the tenting process.

As illustrated in FIG. 4B, the electrode positioned at the uppermost layer of the laminated capacitor 450 is formed such that the first electrode 310 of the capacitor 350a and the conductor patterns for power supply 423P on said first electrode 310 are integrated. Here, the electrode positioned at the uppermost layer of the laminated capacitor 450 refers to the electrode at the surface layer of the capacitor 450 positioned on the side close to the IC chip 800 to be mounted. And, the conductor patterns for power supply 423P on the first electrode 310 are formed of an electroless plated film and an electroplated films on said electroless plated film.

The via conductors 412 connect the second electrodes 320 mutually of the capacitor 350a, the capacitor 350b, and the capacitor 350c. And, the via conductors 412 connect the conductor patterns for ground 421G on the base substrate 100 and the conductor patterns for ground 423G on the first resin insulting layer 200a.

The via conductors 411 connect the first electrodes 310 mutually of the capacitor 350a, the capacitor 350b, and the capacitor 350c. And, the via conductors 411 connect the conductor patterns for power supply 421P on the base substrate 100 and the conductor patterns for power supply 423P on the first resin insulting layer 200a.

Next, as illustrated in FIG. 4C, on the first resin insulting layer 200a, the laminated capacitor 450, and the conductor patterns 423 (423P, 423G, 423S) there is formed the second resin insulating layer 200b. And, in the second resin insulating layer 200b there are formed through holes. And, a surface treatment is performed with a catalyst on the surface of the substrate in which through holes are formed.

Following the surface treatment with a catalyst, there is formed an electroless plated film on the surface of the substrate. Subsequently, a plated resist is formed on the electroless plated film. Following that, the plated resist is treated with exposure and development to pattern the plated resist. And, on the areas where the plated resist is not formed there is formed an electroplated film. After the plated resist is stripped, there are provided the conductor patterns 425 (425P, 425G, 425S) made of an electroless plated film, and an electroplated film on the electroless plated film by removing the electroless plated film between the electroplated films. Following that, as in the case with the first embodiment, the solder resist 700, the pads 427, and the solder bumps 429 are formed to obtain the wiring substrate 900 illustrated in FIG. 3.

In accordance with the method of manufacturing a wiring substrate relating to the present embodiment, it is possible to manufacture the wiring substrate 900 at an easy cost since it can be manufactured with one less resin insulating layer as compared to the first embodiment.

While in the above-described embodiment, the resin insulating layers, conductors patterns, and the via conductors are formed on only one face of the base substrate 100, it is possible to form the resin insulating layers, the conductor patterns, and the via conductors on both faces of the base substrate 100, as illustrated in FIG. 4D.

### (Third embodiment of the wiring substrate in accordance with a specific mode of the present invention)

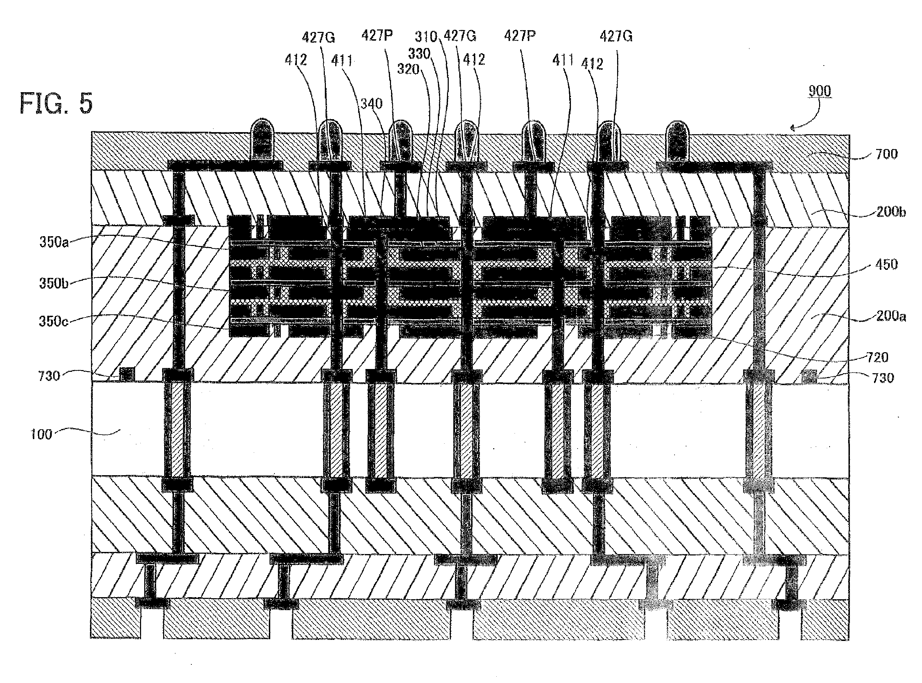

The third embodiment will be illustrated in FIG. 5. In the third embodiment, the first electrodes 310 and the second electrodes 320 are not offset from each other in the direction of the face, unlike the first embodiment. And, in the first electrodes 310 there are provided a plurality of the first opening portions 311, and in the second electrodes 320 there are provided a plurality of the second opening portions 322.

And, a plurality of the first via conductors 411 electrically connect the first electrodes 310 mutually while running through the second opening portions 322 without being in contact with the second electrodes 320. And, a plurality of the second via conductors 412 electrically connect one second electrode to another of the second electrodes 320 while running through the first opening portions 311 without being in contact with the first electrodes 310.

As such, a plurality of the first via conductors 411 and a plurality of the second via conductors 412 penetrate the laminated capacitor 450. Accordingly, in the wiring substrate 900 relating to the third embodiment, it is possible for a plurality of the first via conductors 411 and a plurality of the second via conductors 412 to control the deformation of the adhesive 340 such that the anti-crack property of the laminated capacitor 450 is likely to be improved.

Namely, when the dielectric layer 330 of each of the capacitors (350a, 350b, 350c) and the adhesive 340 adhering each of the capacitors (350a, 350b, 350c) differ in thermal expansion coefficient, the forces such as warpage, torsion, and flexure are applied to the dielectric layers 330 when changed in temperature occur in the laminated capacitor 450. When those forces are applied, since the dielectric layers 330 made of ceramics are thin and further bridle, cracks are likely to occur thereto. However, in the present embodiment, since a plurality of the first via conductors 411 and a plurality of the second via conductors 412 are physically linking each of the capacitors (350a, 350b, 350c) by penetrating the laminated capacitor 450, it is possible to control the deformation of the adhesive 340. Accordingly, it results in the forces such as warpage, torsion and flexure being applied to the dielectric layers 330 becoming small.

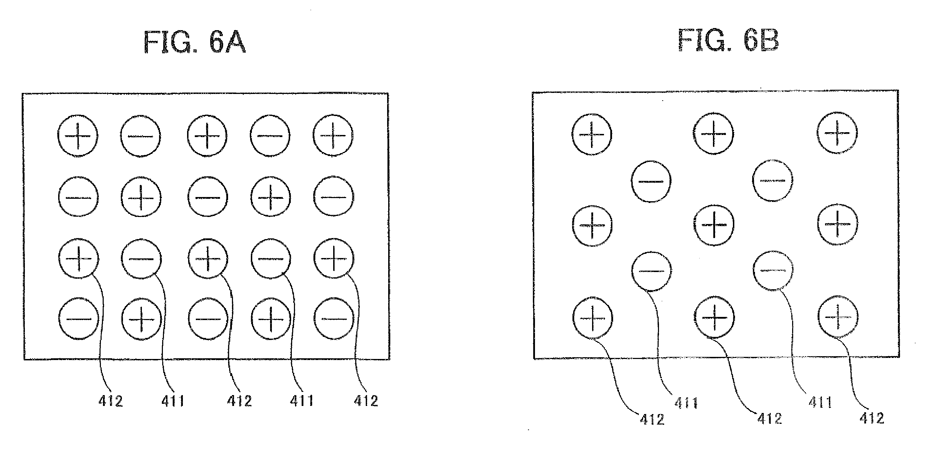

As illustrated in FIG. 6A and FIG. 6B, it is preferred that the via conductors for power supply 411 and the via conductors for ground 412 are disposed in a grid pattern or lattice pattern. The distances between adjacent via conductors for power supply 411 are roughly the same. The distances between adjacent via conductors for ground 412 are roughly the same.

### (A Method of Manufacturing a Wiring Substrate Relating to the Third Embodiment in Accordance with the Present Invention)

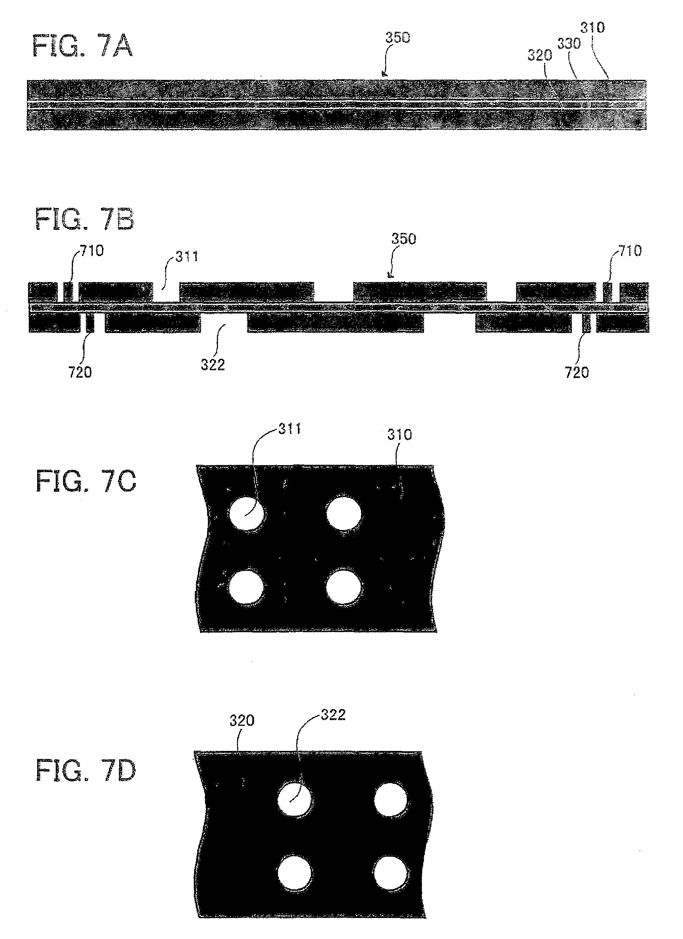

First, as illustrated in FIG. 7A, a capacitor 350 comprising the first electrode 310, the second electrode 320, and the dielectric layer 330 sandwiched between the first electrode 310 and the second electrode 320 is formed. The capacitor 350 is formed likewise as with the first embodiment.

Next, as illustrated in FIG. 7B, in FIG. 7C being a plan view viewing the capacitor 350 from the first electrode 310 side, and in FIG. 7D being a plan view viewing the capacitor 350 from the second electrode 320 side, the first electrode 310 and the second electrode 320 are patterned. At this time, the alignment marks 710 and 720 are concurrently formed.

In the first electrode 310 there are formed the opening portions 311 and inside the opening portions 311 thereof there are formed via conductors for ground 412. The first electrode 310 and the via conductors for ground 412 are not in contact. In the second electrode 320 there are formed the opening portions 322, and inside the opening portions 322 thereof there are formed via conductors for power supply 411. The second electrode 320 and the via conductors for power supply 411 are not in contact.

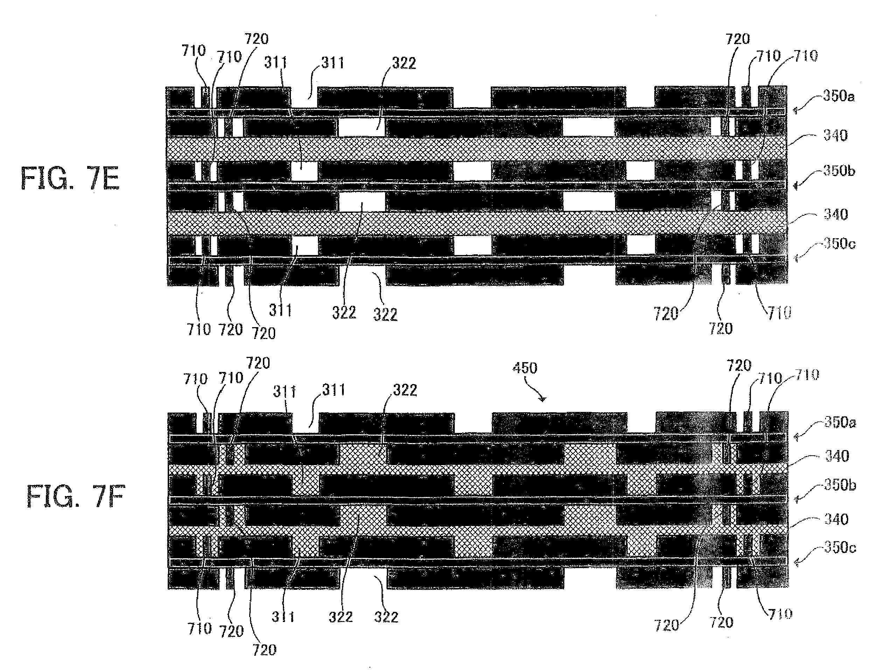

Next, as illustrated in FIG. 7E, three sets of capacitors 350 obtained by the preceding step are prepared, and laminated via the adhesive 340. The capacitors 350a, 350b, and 350c are aligned based on the alignment marks 710, 720 of each of the capacitors 350.

Next, as illustrated in FIG. 7F, the laminated capacitor 450 comprising the capacitors 350a, 350b, 350c and the adhesive 340 disposed in between each of the capacitors is formed. The laminated capacitor 450 is formed with a vacuum press. The conditions for the vacuum press are the temperatures being 50 to 170°C and the pressure being 0.4 to 1.5 MPa.

The opening portions 311 of each of the capacitors constituting the laminated capacitor 450 are formed at nearly the same positions in the sectional direction such that the first electrodes 310 and the second electrodes 320 are not short-circuited by the via conductors 412 penetrating the laminated capacitor 450. Namely, as illustrated in FIG. 7F, the opening portions 311 formed in the capacitors 350a, 350b, 350c are provided at the positions that overlap each other in the sectional direction.

The opening portions 322 of each of the capacitors constituting the laminated capacitor 450 are formed at nearly the same positions in the sectional direction such that the first electrodes 310 and the second electrodes 320 are not short-circuited by the via conductors 411 penetrating the laminated capacitor 450. Namely, in FIG. 7F, the opening portions 322 formed in the capacitors 350a, 350b, 350c are provided at the positions that overlap each other in the sectional direction.

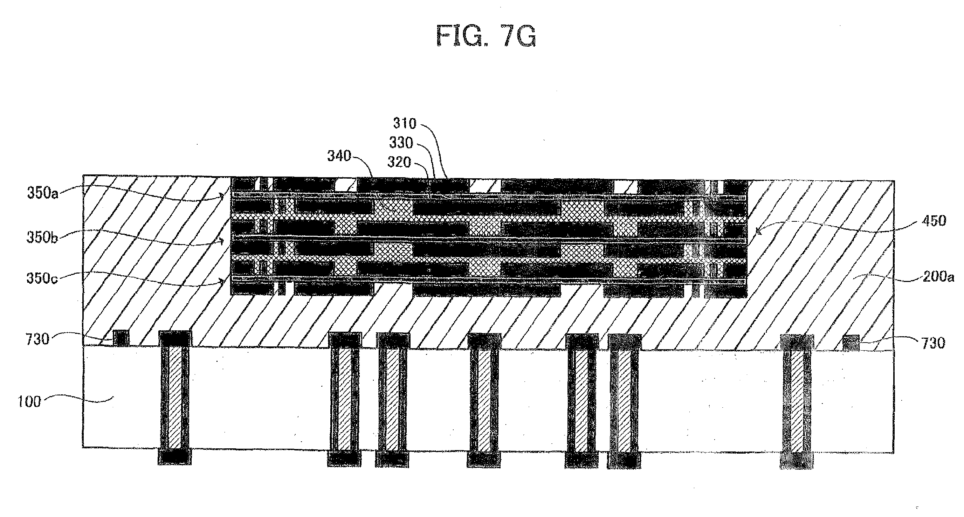

Next, as illustrated in FIG. 7G, the laminated capacitor 450 is embedded in the first resin insulating layer 200a.

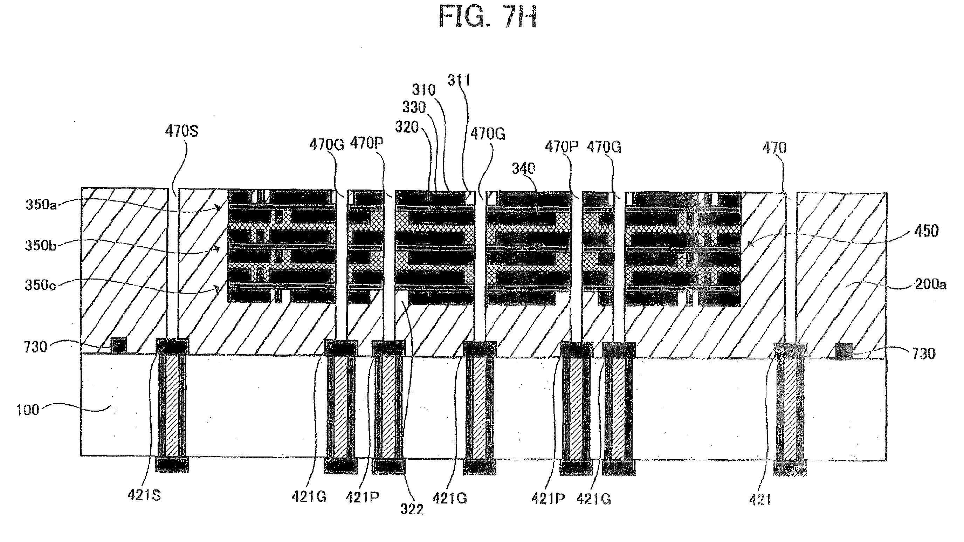

Next, as illustrated in FIG. 7H, the through holes 470 (470P, 470G, 470S) are formed. The through holes 470 (470P, 470G, 470S) run through the laminated capacitor 450 and the first resin insulating layer 200a, and reach the conductor patterns 421 (421P, 421G, 421S) of the base substrate 100. As to the positions for the through holes 470 (470P, 470G, 470S) to be formed at, they are formed by the laser processing with one of the alignment mark 730 of the base substrate 100 and the alignment marks 710, 720 formed on the laminated capacitor 450 as the basis.

The through holes for power supply 470P run through the first electrodes 310 and the dielectric layers 330. And, the through holes for power supply 470P are formed inside the opening portions 322 of the second electrodes 320, and not in contact with the inside walls of the opening portions 322.

The through holes for ground 470G run through the second electrodes 320 and the dielectric layers 330. And, the through holes for ground 470G are formed inside the opening portions 311 of the first electrodes 310, and not in contact with the inside walls of the opening portions 311.

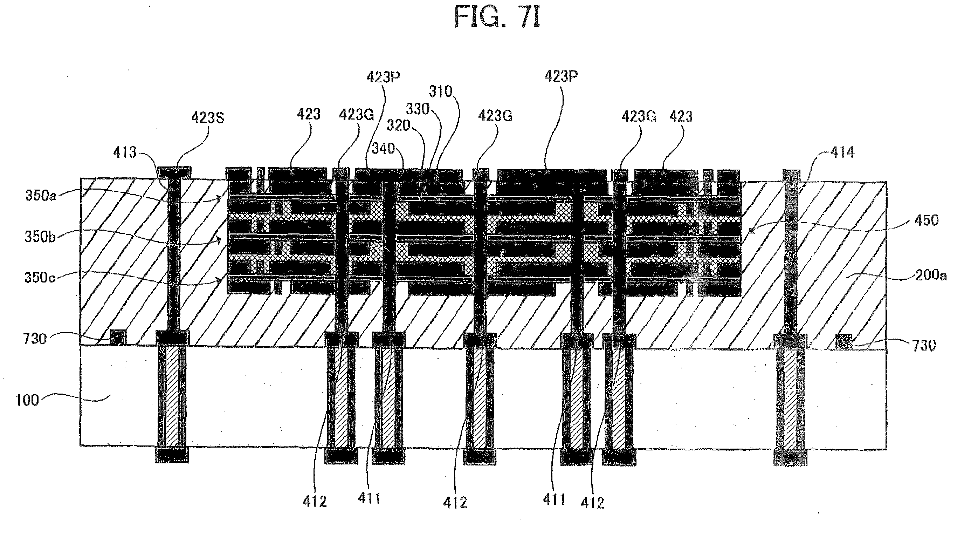

Next, as illustrated in FIG. 7I, the via conductors for ground 412, the via conductors for power supply 411, the via conductors for signal 413, and the conductor patterns 423 (the conductor patterns for power supply 423P, the conductor patterns for ground 423G, the conductor patterns for signal 423S) are formed with the tenting process. The conductor patterns 423 (the conductor patterns for power supply 423P, the conductor patterns for ground 423G, the conductor patterns for signal 423S) comprise electroless plated fams and electroplated films on said electroless plated films.

The uppermost layer electrode of the laminated capacitor 450 is formed such that the first electrode 310 of the capacitor 350a and the conductor patterns for power supply 423P (the electroless plated films on the first electrode 310 and the electroplated films on said electroless plated films) are integrated. The uppermost layer electrode of the laminated capacitor 450 refers to the surface layer electrode being of the laminated capacitor 450 being positioned at the close side to the IC chip to be mounted.

Next, following the via conductors and the conductor patterns being formed, the wiring substrate 900 as being illustrated in FIG. 5 is obtained via the steps being illustrated in FIG. 4C and FIG. 4D.

### (Fourth embodiment of the wiring substrate in accordance with a specific mode of the present invention)

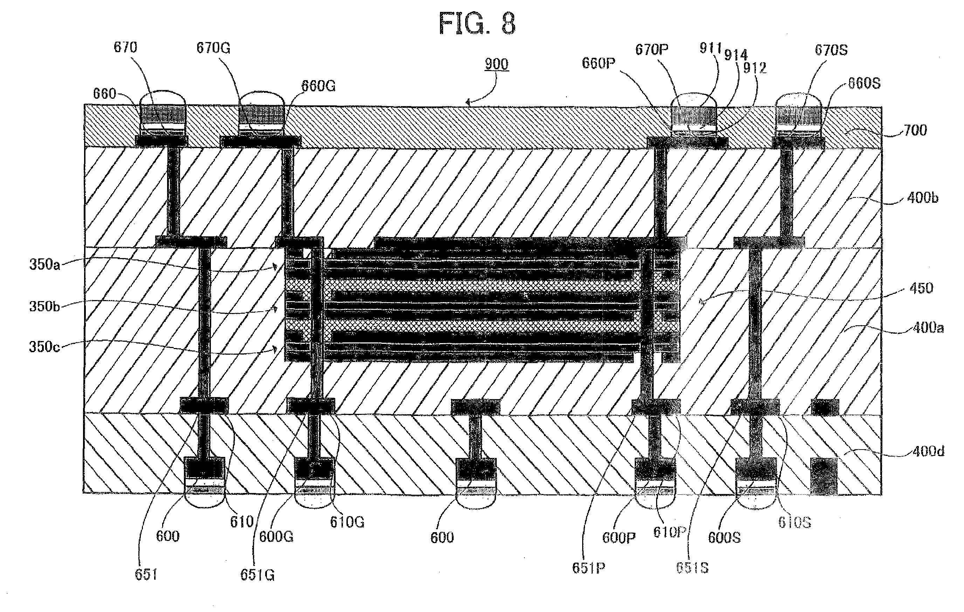

The wiring substrate 900 relating to the fourth embodiment in accordance with the present invention is illustrated in FIG. 8. The wiring substrate 900 relating to the fourth embodiment is such, unlike the wiring substrate 900 relating to the first embodiment, that the base substrate (core substrate) 100 having a core material such as glass cloth and fiber glass is not provided. Accordingly, all the insulating layers can be resin insulating layers (resin films). Thus, the capacitor substrate with a built-in capacitor can be made thin. In accordance with the wiring substrate 900 relating to the fourth embodiment, the distance between the external power supply and the laminated capacitor 450 built-in in the wiring substrate 900 and the distance between the chip capacitor (a drawing omitted) mounted on the surface of the wiring substrate 900 and the laminated capacitor 450 can be made short.

### (A Method of Manufacturing a Wiring Substrate Relating to the Fourth Embodiment in Accordance with the Present Invention)

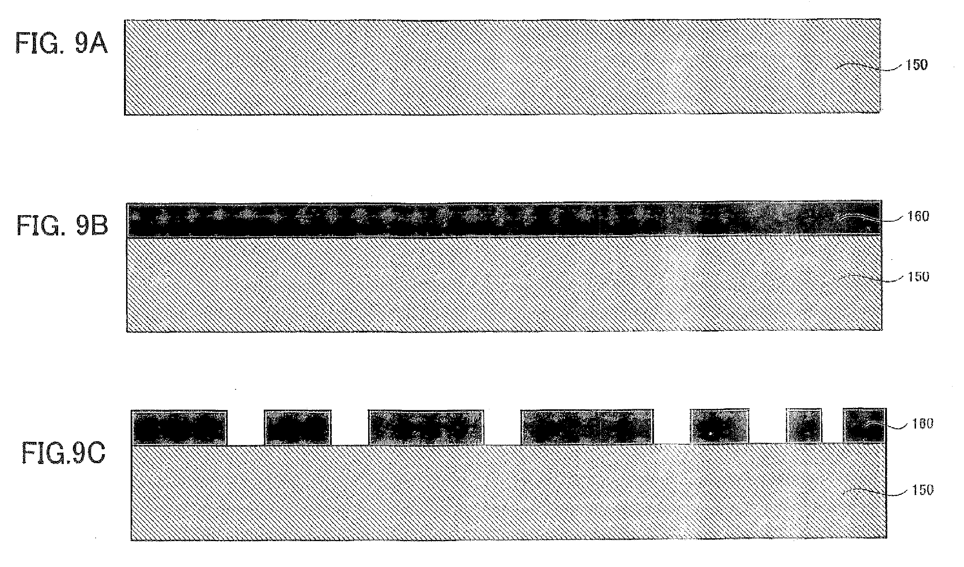

First, as illustrated in FIG. 9A, the support board 150 is prepared. The support board 150 is a copper board, for example. It is possible to use, other than copper, a metal board such as a nickel board, an aluminum board, and an iron board for the support board 150 material.

Next, as illustrated in FIG. 9B, the plated resist 160 is formed on the support board 150.

Next, as illustrated in FIG. 9C, a plurality of opening portions are provided in the plated resist 160 by the plated resist 160 being patterned with the exposure and development steps.

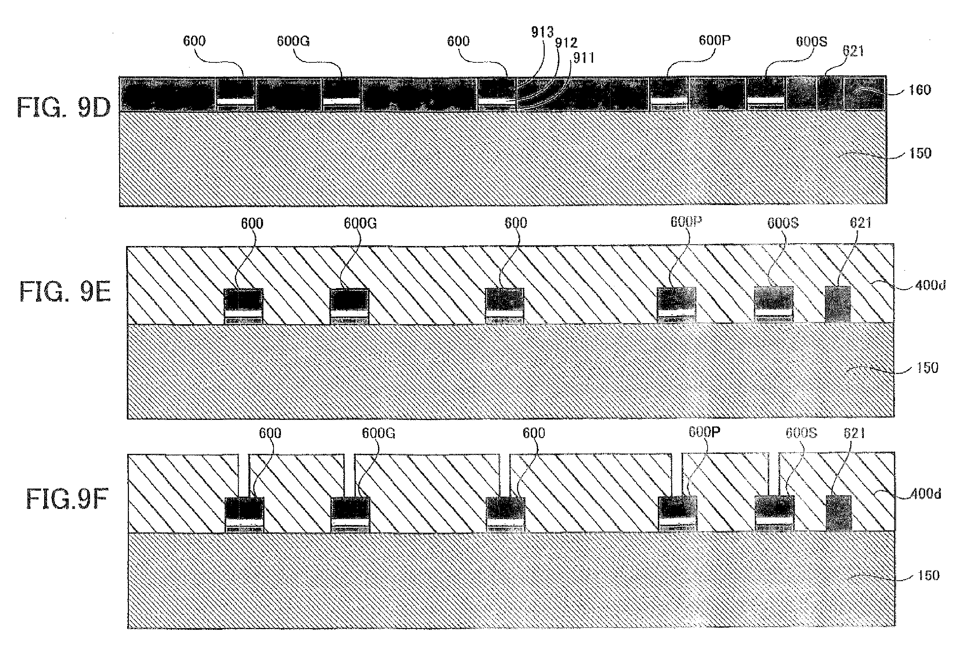

Next, as illustrated in FIG. 9D, the opening portions provided in the plated resist 160 are electroplated with the gold-plated film 911, the nickel-plated film 912, and the copper-plated film 913 in that order, and there are formed the first external connection terminals 600 (the external terminals for power supply (the first external terminals) 600P, the external terminals for ground (the second external terminals) 600G, the external terminals for signal 600S). Concurrently, on the support board 150 there is formed the alignment mark (the first alignment mark) 621. It is possible to form a palladium film between the gold-plated film 911 and the nickel-plated film 912.

Next, as illustrated in FIG. 9E, the plated resist 160 is stripped and the resin film (the first lower resin insulating layer) 400d is formed. This first lower resin insulating layer (the lowest layer resin insulation) 400d is present, as illustrated in FIG. 8, below the first resin insulating layer 400a having the laminated capacitor 450 built-in. As illustrated in FIG. 9E, the first external connection terminals 600 (600P, 600G, 600S) are embedded in the lowest resin insulating layer (the first lower resin insulating layer) having the first face and the second face which is on the opposite side from the first face. And, the surfaces of the first external connection terminals 600 are positioned on nearly the same plane as the first face of the lowermost resin insulating layer.

Next, as illustrated in FIG. 9F, through holes reaching the first external connection terminals 600 (600P, 600G, 600S) are formed in the first lower resin insulating layer 400d.

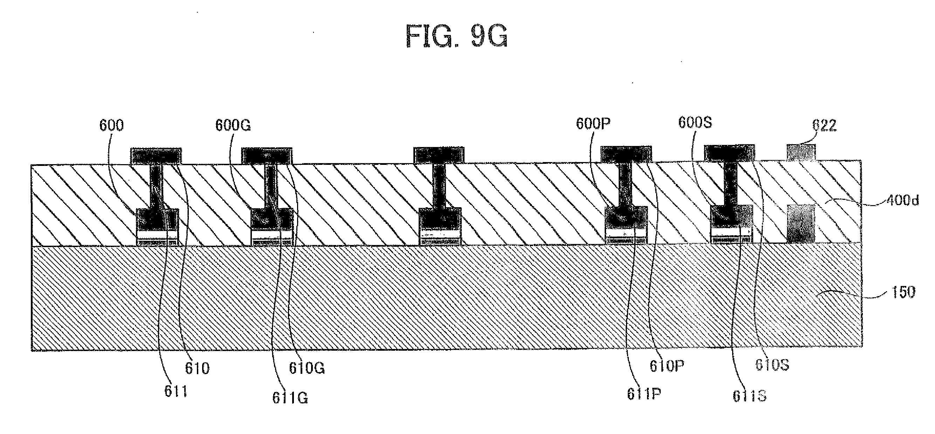

Next, as illustrated in FIG. 9G, the first conductor patterns 610 (the first conductor patterns for power supply 610P, the first conductor patterns for ground 610G, the first conductor patterns for signal 610S) are formed with the semi-additive process on the upper face of the first lower resin insulating layer 400d (the opposite face from the face on which the external terminals are formed).

Concurrently, the first via conductors 611 (the first via conductors for power supply 611P, the first via conductors for ground 611G, the first via conductors for signal 611S) are formed connecting the first external connection terminals 600 (600P, 600G, 600S) and the first conductor patterns 610 (610P, 610G, 610S). At that time, the second alignment mark 622 is concurrently formed.

The first via conductors for power supply 611P connect the external terminals for power supply 600P on the first face side (the first external terminals for power supply) and the first conductor patterns for power supply 610P. The first via conductors for ground 611G (the first external terminals for ground) connect the external terminals for ground 600G on the first face side and the first conductor patterns for ground 610G. The first via conductors for signal 611S (the first external terminals for signal) connect the external terminals for signal 600S on the first face side and the first conductor patterns for signal 610S.

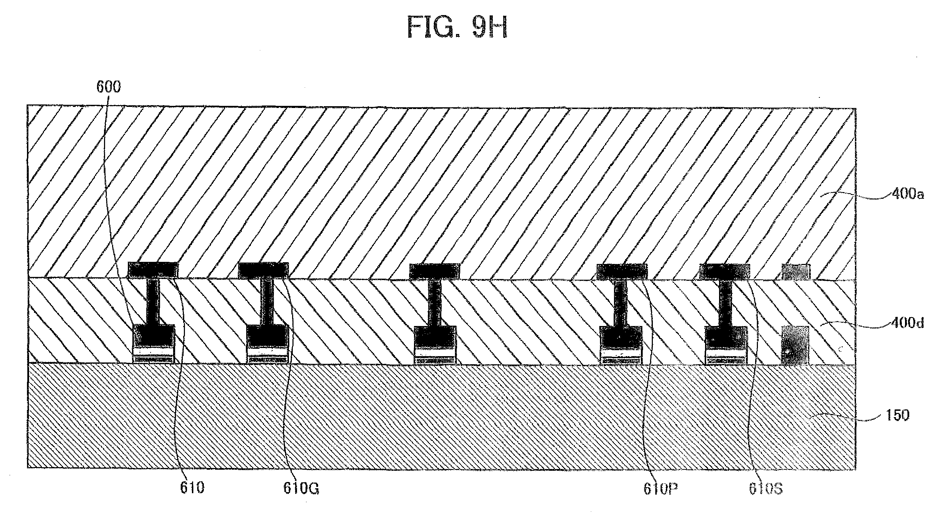

Next, as illustrated in FIG. 9H, on the first conductor patterns 610 (610P, 610G, 610S) and the first lower resin insulating layer 400d there is formed a resin film (the first resin insulating layer 400a) having the first face and the second face being on the opposite side from the first face. For the formation of the first resin insulating layer 400a, two sheets of ABF-45SH made by Ajinomoto Co., Inc., are overlapped which can be laminated.

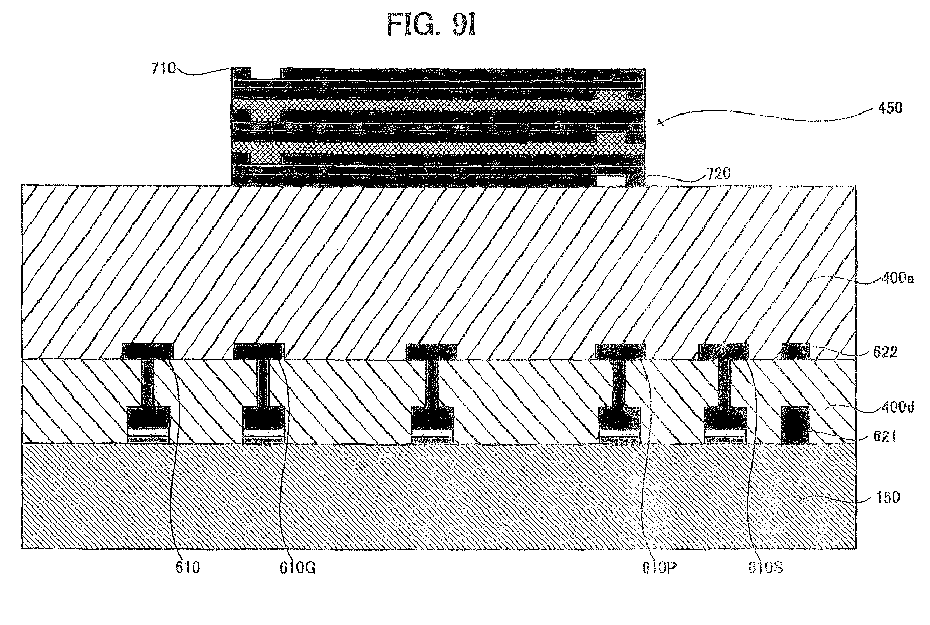

Next, as illustrated in FIG. 9I, the laminated capacitor 450 is laminated on the first resin insulating layer 400a such that they are aligned. The lamination position of the laminated capacitor 450 can be determined using the second alignment mark 622 formed on the first resin insulating layer 400a and the alignment mark 720 of the laminated capacitor 450, for example. The laminated capacitor 450 can be formed by the manufacturing method which is the same as that of the first embodiment.

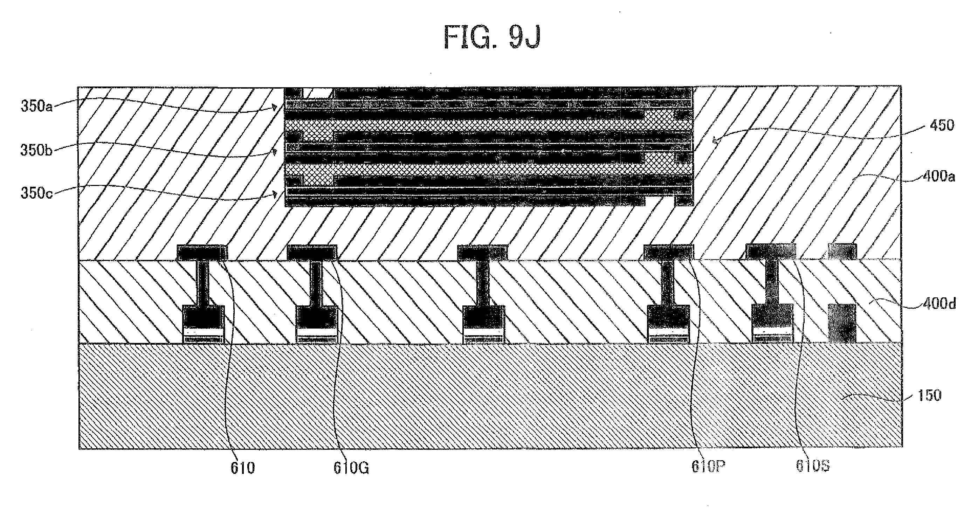

Next, as illustrated in FIG. 9J, the laminated capacitor 450 is embedded on the second face side of the first resin insulating layer 400a. The surface of the first electrode 310 of the capacitor 350a and the second face of the first resin insulating layer 400a are disposed on nearly the same plane. The method of embedding the laminated capacitor 450 is the same as the method described with FIG. 2G.

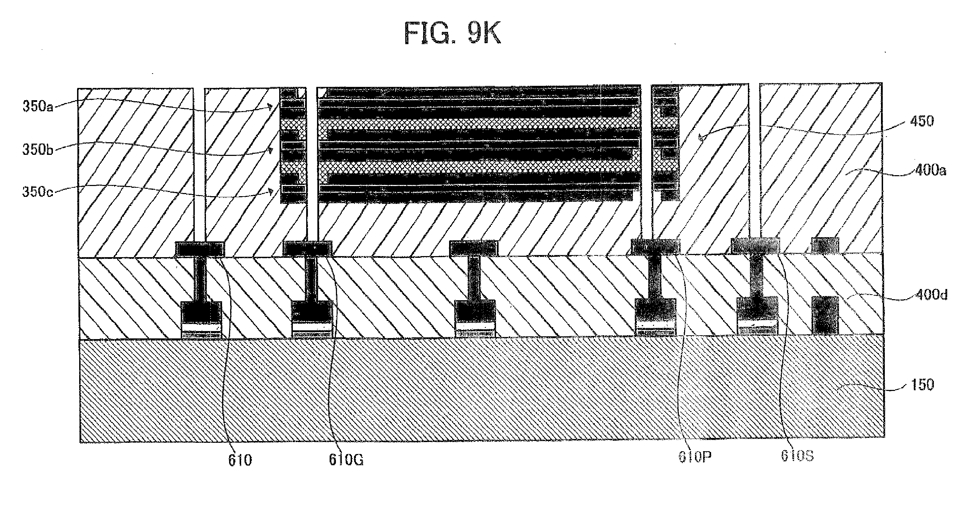

Next, as illustrated in FIG. 9K, through holes are formed.

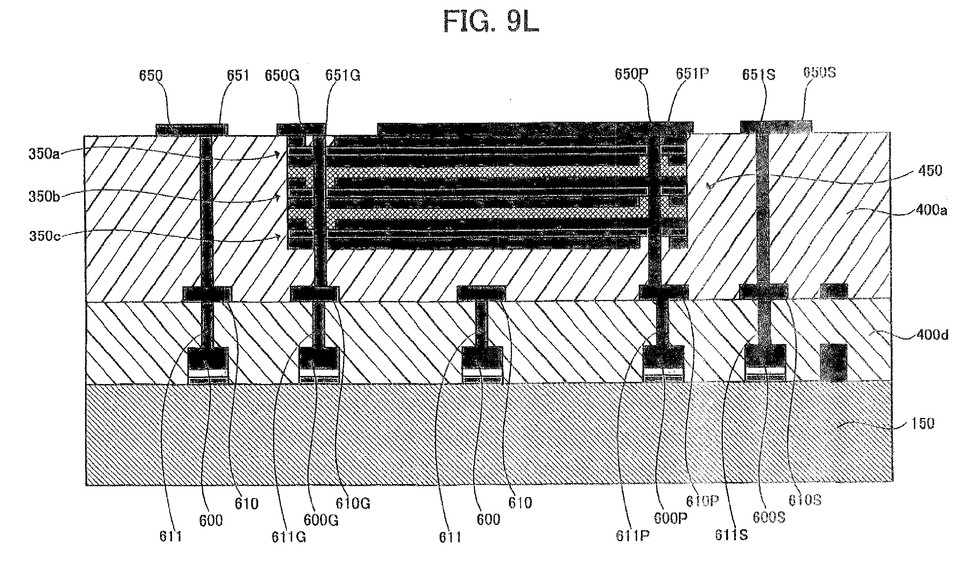

Next, as illustrated in FIG. 9L, the via conductors (the second via conductors) 651 (the second via conductors for power supply 651P, the second via conductors for ground 651G, the second via conductors for signal 651S) are formed. And, the second conductor patterns 650 (the second conductor patterns for power supply 650P, the second conductor patterns for ground 650G, the second conductor patterns for signal 650S) are formed.

The second via conductors for power supply 651P connect one first electrode 310 to another of the first electrodes 310 of each of the capacitors 350a, 350b, 350c of the laminated capacitor 450. Further, the via conductors 651P connect the second conductor patterns for power supply 650P and the first conductor patterns for power supply 610P.

The second via conductors for ground 651G connect the second electrodes 320 mutually of each of the capacitors 350a, 350b, 350c of the laminated capacitor 450. Further, the via conductors 651G connect the second conductor patterns for ground 650G and the first conductor patterns for ground 610G.

The via conductors for signal 651S connect the second conductor patterns for signal 650S and the first conductor patterns for signal 610S.

Via the first conductors for power supply 611P, the conductor patterns 610P, and the via conductors 651P, the first electrodes 310 of each of the capacitors 350a, 350b, 350c and the first external terminals 600P are electrically connected. And, via the first via conductors for ground 611G, the conductor patterns 610G, and the via conductors 651G, the second electrodes 320 of each of the capacitors 350a, 350b, 350c and the second external terminals 600G are electrically connected.

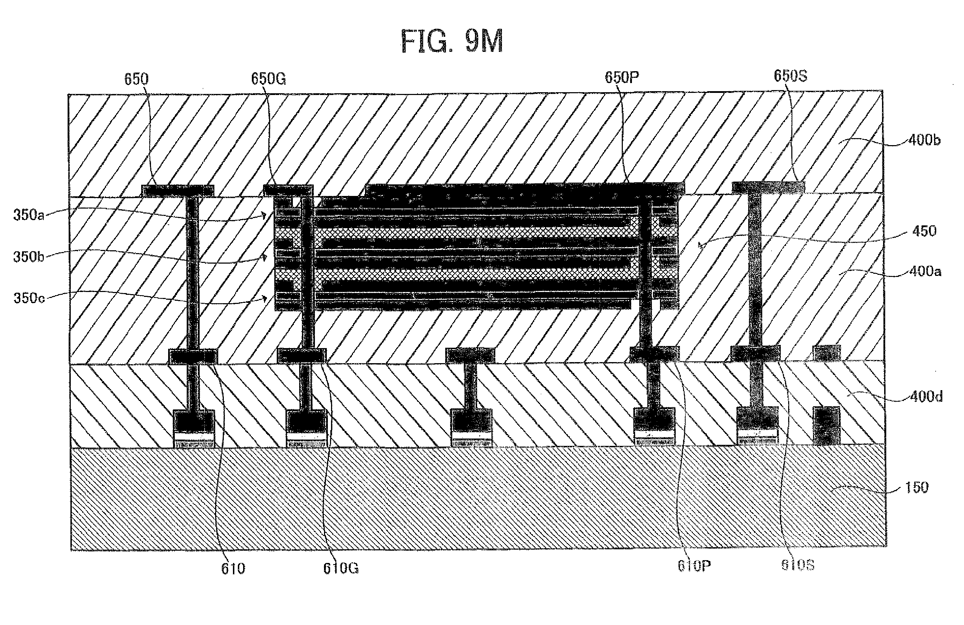

Next, as illustrated in FIG. 9M, on the second conductor patterns 650 (650P, 650G, 650S) and the first resin insulating layer 400a there is formed the resin film (the second resin insulating layer) 400b.

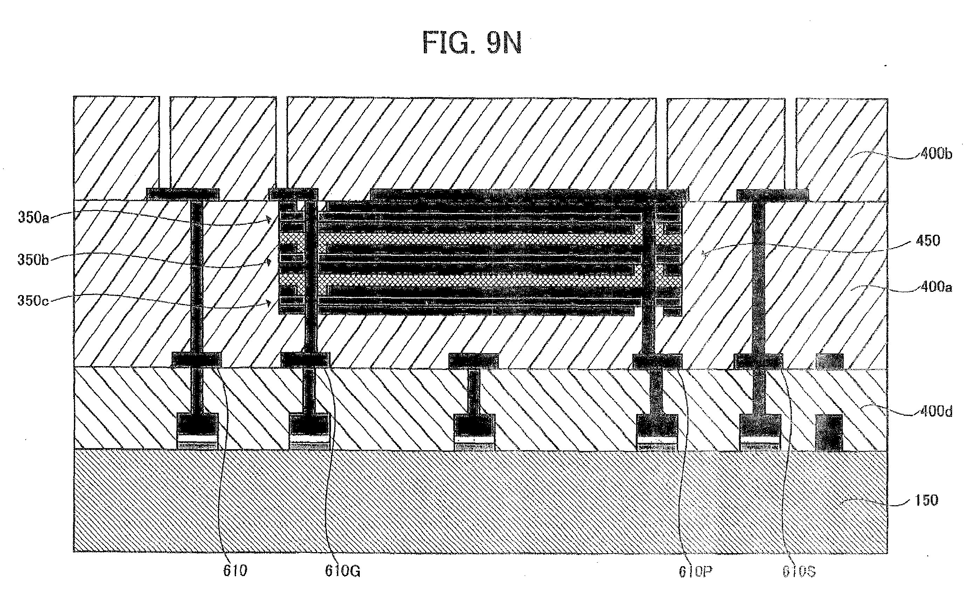

Next, as illustrated in FIG. 9N, in the second resin insulating layer (the uppermost resin insulating layer) 400b there are formed through holes.

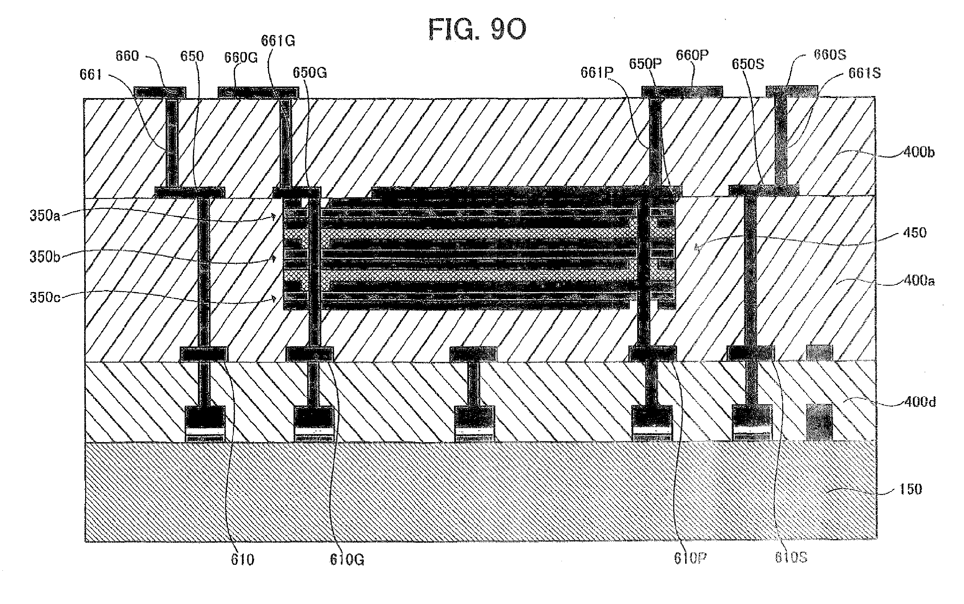

Next, as illustrated in FIG. 9O, on the second resin insulating layer 400b there are formed the third conductor patterns 660 (the third conductor patterns for power supply 660P, the third conductor patterns for ground 660G, the third conductor patterns for signal 660S).

Concurrently, the third via conductors 661 (the third via conductors for power supply 661P, the third via conductors for ground 661G, the third via conductors for signal 661S) connecting the second conductor patterns 650 (650P, 650G, 650S) and the third conductor patterns 660 (660P, 660G, 660S) are formed.

The third via conductors for power supply 661P connect the third conductor patterns for power supply 660P and the second conductor patterns for power supply 650P. The third via conductors for ground 661G connect the third conductor patterns for ground 660G and the second conductor patterns for ground 650G. The third via conductors for signal 661S connect the second conductor patterns for signal 650S and the third conductor patterns for signal 660S. These connections can be formed with the semi-additive process, for example.

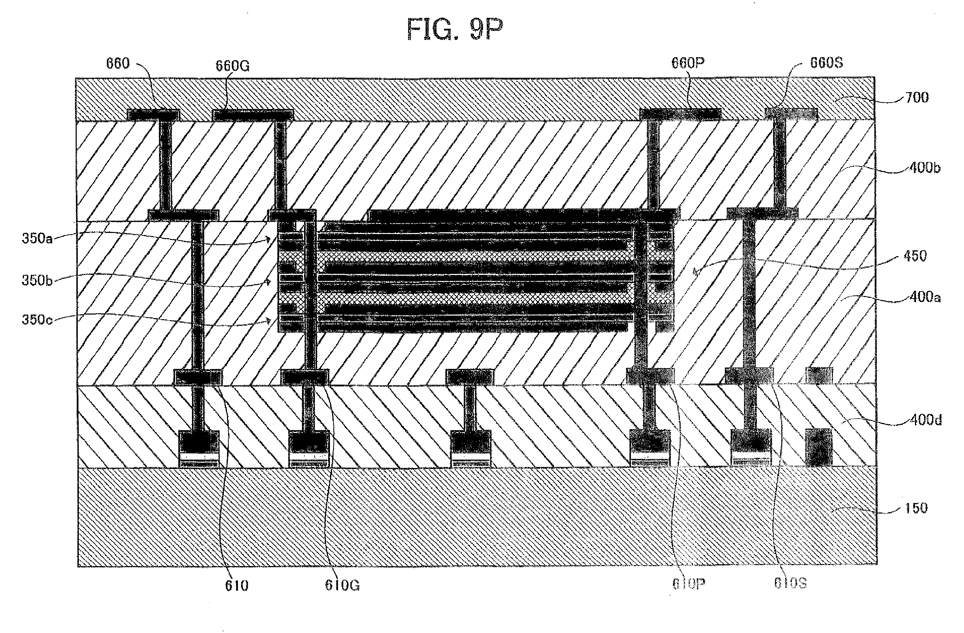

Next, as illustrated in FIG. 9P, on the second resin insulating layer 400b and the third conductor patterns 660 (660P, 660G, 660S) there is formed the solder resist 700.

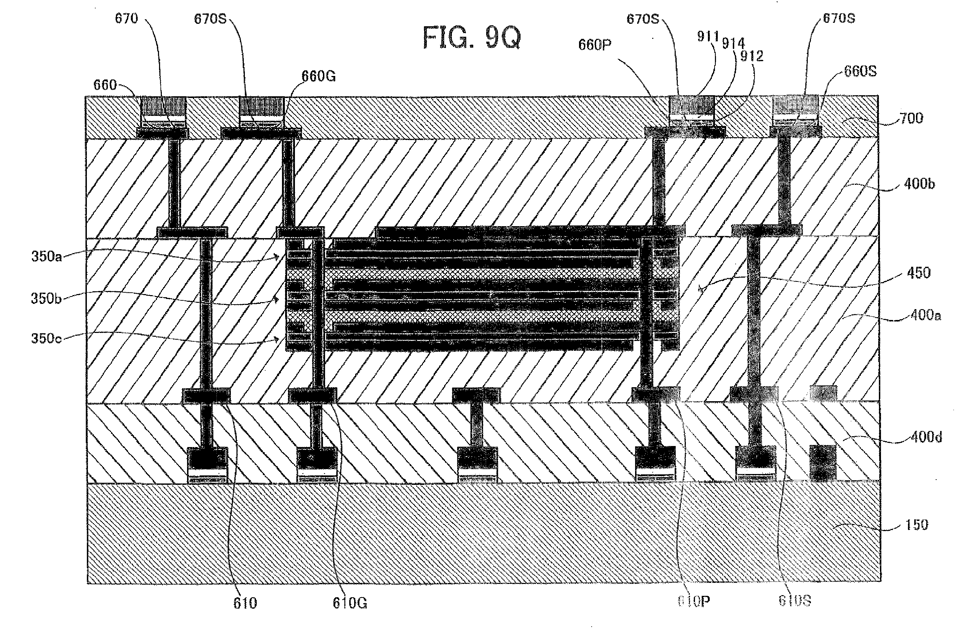

Next, as illustrated in FIG. 9Q, there are provided a plurality of opening portions in the solder resist 700. Those opening portions partially open up the third conductor patterns 660 (660P, 660G, 660S). The portions of the third conductor patterns 660 (660P, 660G, 660S) exposed by the opening portions constitute the second external connection terminals 670 (670P, 670G, 670S). The second external connection terminals 670 are formed on the second resin insulating layer (the uppermost resin insulating layer) 400b, comprising the second external connection terminals for power supply (the third external terminals) 670P, the second external connection terminals for ground (the fourth external terminals) 670G, and the second external connection terminals for signal 670P.

Next, on the second external connection terminals 670 (670P, 670G, 670S) plating is performed in the order of the nickel-plated film 912, the palladium-plated film 914, and the gold-plated film 911 to form a metal film comprising three layers. The metal film may be of one layer of a gold-plated layer and of two layers of a nickel-plated layer and a gold-plated layer on the nickel-plated layer.

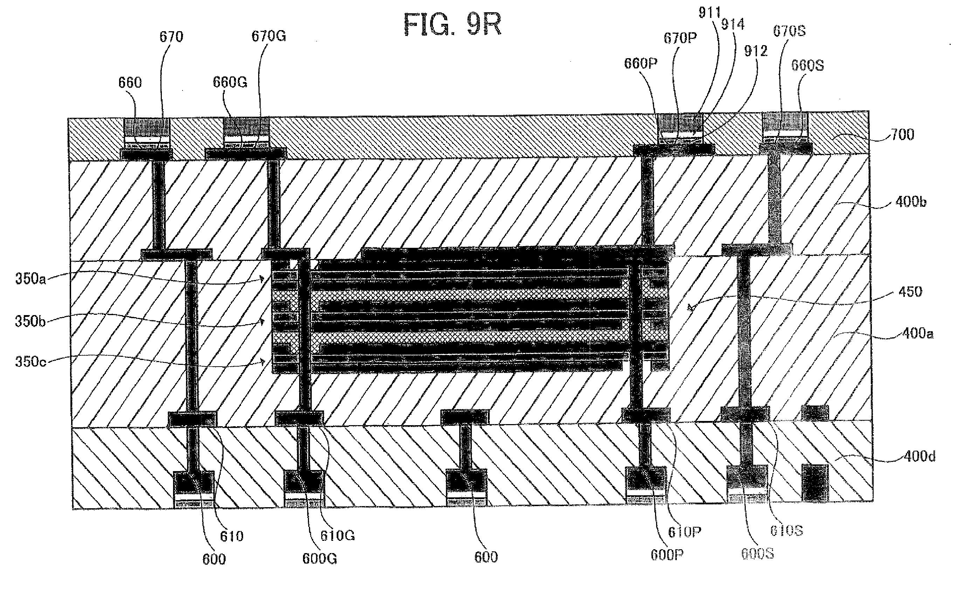

Next, as illustrated in FIG. 9R, the support board 150 is etch-removed with a cupric chloride etching solution. At that time, the support board 150 can be removed without the external connection terminals being etch-removed on account of metal films being formed on the second external connection terminals 670 (670P, 670G, 670S) and the first external connection terminals 600 (600P, 600G, 600S). The removal of the support board 150 exposes the external terminal faces (the exposed portions of the metal films) of the first external connection terminals 600.

Subsequently, the wiring substrate 900 illustrated in FIG. 8 is obtained by the second solder bumps being formed on the external terminal faces (the exposed portions of the metal films) of the second external connection terminals 670 (670P, 670G, 670S) and by the first solder bumps being formed on the external terminal faces of the first external connection terminals 600 (600P, 600G, 600S).

An electronic device such as an IC chip may be loaded via the first solder bumps. It may be connected to another substrate (a motherboard) via the second solder bumps. And, while in FIG. 8 solder bumps are formed on the external terminal faces of the first external connection terminals 600 and on the external terminal faces of the second external connection terminals 670, it may be that the solder bumps on the outer terminal faces of the second external connection terminals 670 and conductive pins are loaded (mounted) on the external terminal faces of the first external connection terminals 600 via soldering. It may be that the solder bumps on the outer terminal faces of the first external connection terminals 600 and conductive pins are loaded (mounted) on the external terminal faces of the second external connection terminals 670 via soldering. While the IC chip may be loaded on the upper face side or the lower face side of the wiring board, it is preferred that the IC chip be loaded on the surface of the substrate with a built-in capacitor on the side where the distance between the external terminals and the capacitor is short (the distance in the sectional direction of the substrate).

In the present embodiment, while the resin insulating layer (the resin film) is of three layers, it is possible for it to be multi-layered with four layers or more by repeating the steps of FIG. 9M through FIG. 9O.

And, it is possible to form on the lower face of the first resin insulating layer a solder resist having opening portions allowing the first external connection terminals 600 (600P, 600G, 600S) to be exposed.

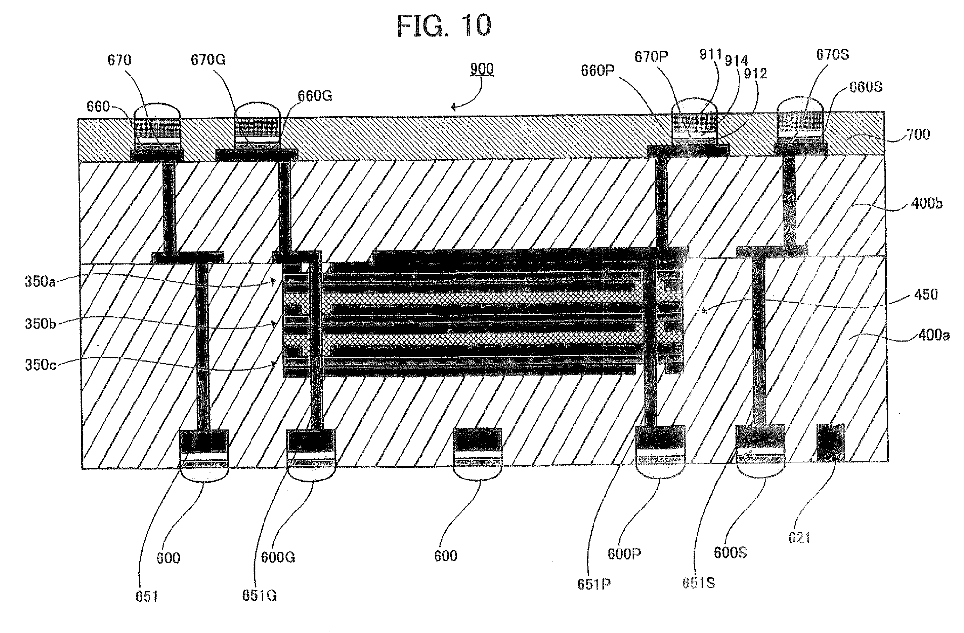

The wiring substrate 900 illustrated in FIG. 10 is, unlike the wiring substrate 900 illustrated in FIG. 8, an example wherein the first external connection terminals 600 and the laminated capacitor 450 are embedded in the same resin insulating layer. The wiring substrate 900 illustrated in FIG. 10 is of the two-layer structure with the first resin insulating layer (the lowermost resin insulating layer) 400a having the first face and the second face being on the opposite side from the first face and the second resin insulating layer (the uppermost resin insulating layer) 400b having the first face and the second face being on the opposite side from the first face. In the second face side of the first resin insulating layer 400a there is embedded the laminated capacitor 450. The surface of the first electrode 310 of the capacitor 350a and the second face of the lowermost resin insulating layer 400a are disposed on nearly the same plane. Alternately, on the first face side (the first surface of the wiring board 900) of the first resin insulating layer 400a there are embedded the first external connection terminals 600. The surfaces of the first external connection terminals 600 and the first face of the lowermost resin insulating layer 400a are disposed on nearly the same plane. On the second face of the lowermost resin insulating layer 400a there is laminated the first face of the uppermost resin insulating layer 400b. On the second face of the second resin insulating layer 400b there are formed the second external connection terminals 670 comprising the second external connection terminals for power supply (the third external terminals) 670P, the second external connection terminals for ground (the fourth external terminals) 670G, and the second external connection terminals for signal 670P. And, in the second resin insulating layer 400b there are formed via conductors.

The method of manufacturing the wiring board 900 illustrated in FIG. 10 first undertakes the steps illustrated in FIG. 9A through FIG. 9E. Subsequently, it undertakes the steps illustrated in FIG. 9I through FIG. 9R, the plating resist 160 being removed and the first solder bumps being formed on the first external connection terminals 600 (600P, 600G, 600S) to obtain the wiring substrate 900 illustrated in FIG. 10.

The printed wiring board in accordance with the fourth embodiment may, as with the third embodiment, have a laminated capacitor built in wherein the capacitors wherein the first electrodes and the second electrodes not being offset in the direction of the face are laminated with an adhesive.

### (Fifth embodiment of the wiring substrate in accordance with a specific mode of the present invention)

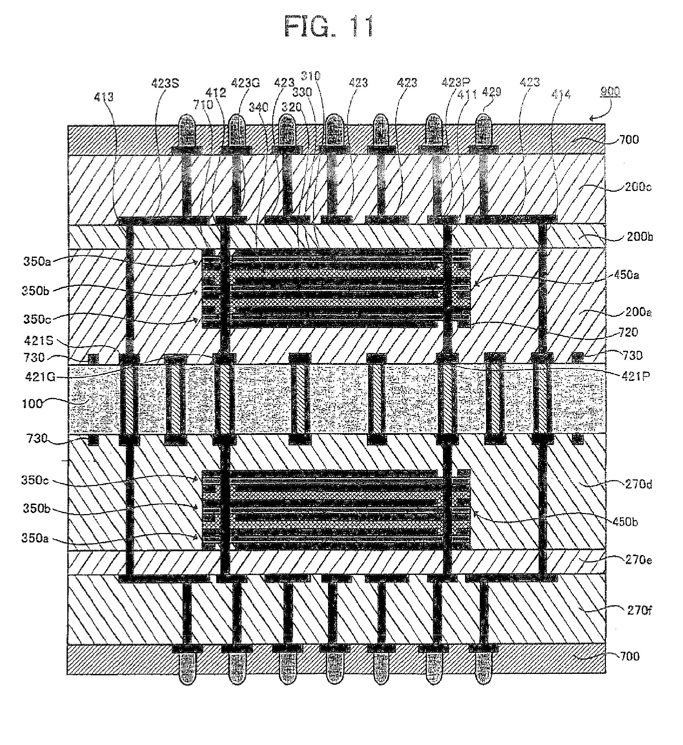

The wiring board 900 relating to the fifth embodiment in accordance with the present invention is such, unlike the wiring board 900 relating to the first embodiment, that there are provided the resin insulating layer 200a on and the lower resin insulating layer 270d underneath the base substrate 100 as shown in FIG. 11. And, in the resin insulating layer 200a there is embedded the laminated capacitor 450a, and in the lower resin insulating layer 270d there is embedded the laminated capacitor 450b.

The constitution as such allows not only a reduction in noise on the base substrate 100 but also a reduction in noise also underneath the base substrate 100 to be effectively worked out.

As to the method of manufacturing this wiring substrate 900, it is possible, following FIG. 2Q, for example, for the lower resin insulating layer 270d to be provided on the lower face of the base substrate 100 and that the laminated capacitor 450b is embedded in that lower resin insulating layer 270d such that it is formed.

### (Other embodiments in accordance with the present invention)

In the above-described embodiments the laminated capacitor 450 was formed such that three capacitors 350a, 350b, 350c were laminated. Naturally, it is not limited to this. The laminated capacitor 450 can be such that two or four to thirty or more capacitors, for example, are laminated with the adhesive 340 interposed.

In the above-described embodiments, the dielectric layer 330 was formed of barium titanate (BaTiO₃). Naturally, it is not limited to this. It is possible to use for the dielectric layer 330 any or a mixture of strontium titanate (SrTiO₃), tantalum oxide (TaO₃, Ta₂O₅), lead zirconate titanate (PZT), lead lanthanum zirconate titanate (PLZT), lead niobium zirconate titanate (PNZT), lead calcium zirconate titanate (PCZT), and lead strontium zirconate titanate (PSZT).

In the above-described embodiments, strontium titanate (SrTiO₃) was used as a dielectric filler. Naturally, it is not limited to this. For a dielectric filler, it is possible to use, for example, calcium titanate (CaTiO₃), magnesium titanate (Mg₂TiO₃), neodymium titanate (Nd₂Ti₂O₇), etc.

And, in the above-described embodiments, epoxy resins were used for resins constituting resin insulating layers (resin films). Naturally, this is not limited to this. For a resin constituting a resin insulating layer, polyimide, polycarbonate, denatured polyphenylene ether, polyphenylene oxide, polybutylene terephthalate, polyacrylate, polysulfone, polyphenylenesulfide, polyetheretherketone, polysalfone, polyethersalfone, polyphenysalfone, polyphtalamide, polyamideimide, polyketone, polyacetal, etc., for example, alone or a combination thereof with an epoxy resin may be used.

And, in the above-described embodiments, copper was used as a metal constituting the first electrode 310 and the second electrode 320. Naturally, this is not limited to this. As a metal constituting the first electrode 310 and the second electrode 320, platinum, gold, nickel, tin, silver, etc., for example, alone or a mixture thereof may be used. Further, it is possible to use a different kind of metal for the first electrode 310 and the second electrode 320 each.

And, in the above-described embodiments, a capacitor was formed such that on the first electrode 310 made of copper there was printed a high dielectric material which was baked to form a dielectric layer 330 and subsequently that a metal layer made of copper was formed on the dielectric layer 330 with the use of a vacuum evaporation apparatus such as sputtering, etc. Naturally, this is not limited to this.
Namely, it is possible to make a capacitor with the following steps. First, diethoxy barium and titanium bitetraisopropoxide are dissolved in a mixture solvent of dehydrated methanol and 2-methoxy ethanol, which is stirred for three days under nitrogen atmosphere at room temperature to adjust a alkoxide precursor composition solution of barium and titanium. Next, this precursor composition solution being stirred while being maintained at 0°C, water which has in advance been decarboxylated is sprayed under a nitrogen flow at the rate of 0.5 microliter/minute for hydrolysis. The sol gel solution prepared as such is passed through a filter such that a precipitate, etc., are filtered. The filtrate obtained is spin-coated onto the first electrode 310 made of copper being 12 µm in thickness. Subsequently, it is inserted into an electric furnace maintained at 850°C and baked to obtain the dielectric layer 330. And, a copper layer is formed on the dielectric layer 330 with the use of a vacuum evaporation apparatus such as sputtering, etc., and, further, copper is added onto this copper layer by about 10 µm by electroplating, etc., to obtain the second electrode 320.

The present application is based on the United States Provisional Patent Application No. 60/980969 filed on October 18, 2007. The entity of the specification, claims and the drawings are incorporated herein by reference.

### Industrial Applicability

The present invention can be used for a wiring board with built-in capacitors with a high capacitance and the insulation resistance secured.

Further disclosure is given in the items below:
1. A wiring substrate comprising:
   a laminated capacitor formed by laminating capacitors via an adhesive, the capacitor being formed of a dielectric layer and a first electrode and a second electrode sandwiching the dielectric layer and mutually facing;
   a first resin insulating layer with the laminated capacitor built-in;
   a base substrate supporting the first resin insulating layer;
   first via conductors electrically connecting the first electrodes mutually;
   second via conductors electrically connecting the second electrodes mutually;
   first external terminals electrically connected to the first via conductors; and
   second external terminals electrically connected to the second via conductors.
2. The wiring substrate according to item 1, wherein
   the first electrode and second electrode are such that they are disposed mutually offset in the direction of the faces of the electrodes;
   the first via conductors penetrates the end portions of the first electrodes such that they electrically connect the first electrodes mutually; and
   the second via conductors penetrates the end portions of the second electrodes such that they electrically connect the second electrodes mutually.
3. The wiring substrate according to item 1, wherein the upper face of the laminated capacitor is at the upper face of the first resin insulating layer and the upper face of the laminated capacitor and the upper face of the first resin insulating layer are flush with each other.
4. The wiring substrate according to item 1, further comprising:
   a second resin insulating layer being on the first resin insulating layer.
5. The wiring substrate according to item 4, wherein:
   conductor patterns are provided on the base substrate and on the second resin insulating layer; and
   the via conductors electrically connect the conductor patterns on the base substrate and the conductor patterns on the second resin insulating layer.
6. The wiring substrate according to item 4, further comprising:
   a third resin insulating layer being on the second resin insulating layer.
7. The wiring substrate according to item 6, comprising:
   conductor patterns on the second resin insulating layer; and
   conductor patterns on the third resin insulating layer.
8. The wiring substrate according to item 7, comprising:
   via conductors electrically connecting the conductor patterns on the second resin insulating layer and the conductor patterns on the third resin insulating layer.
9. The wiring substrate according to item 3, comprising:
   conductor patterns being provided on the base substrate and on the first resin insulating layer, wherein
   the via conductors electrically connecting the conductor patterns on the base substrate and the conductor patterns on the first resin insulating layer.
10. The wiring substrate according to item 9, wherein the conductor patterns on the first resin insulating layer and the first electrode of the capacitor present at the uppermost face of the laminated capacitor are integrated such that they form an electrode.
11. The wiring substrate according to item 1, wherein
   the first electrodes have a plurality of the first opening portions;
   the second electrodes have a plurality of the second opening portions;
   the first via conductors electrically connect the first electrodes mutually while running through the second opening portions without being in contact with the second electrodes; and
   the second via conductors electrically connect the second electrodes mutually while running through the first opening portions without being in contact with the first electrodes.
12. A wiring substrate comprising:
   a plurality of resin insulating layers having at least a lowermost resin insulating layer and an uppermost resin insulating layer;
   a plurality of conductor circuits formed in between the resin insulating layers;
   a laminated capacitor embedded in one of the plurality of resin insulating layers and formed by laminating capacitors via an adhesive, the capacitor being formed of a dielectric layer and the first electrode and the second electrode sandwiching the dielectric layer and mutually facing;
   first via conductors electrically connecting the first electrodes mutually;
   second via conductors electrically connecting the second electrodes mutually;
   first external connection terminals formed on the lowermost resin insulating layer and comprising the first external terminals electrically connected to the first via conductors and the second external terminals electrically connected to the second via conductors; and
   second external connection terminals formed in the uppermost resin insulating layer and comprising the third external terminals electrically connected to the first via conductors and the fourth external terminals electrically connected to the second via conductors, wherein
   the first external connection terminals are embedded in the lowermost resin insulating layer and concurrently the external terminal faces of the first external connection terminals are positioned on nearly the same plane as the first face of the lowermost resin insulating layer; and
   the second external connection terminals are formed on the uppermost resin insulating layer.
13. The wiring substrate according to item 1, wherein the above-described adhesive is a resin forming the first resin insulating layer.
14. A method of manufacturing a wiring substrate comprising:
   a step of capacitor forming for forming the capacitors having a dielectric layer and the first electrode and the second electrode mutually opposing with the dielectric layer being sandwiched therebetween;
   a step of laminated-capacitor forming for forming a laminated capacitor by laminating the capacitors via an adhesive;
   a step of laminating for laminating the first resin insulating layer on a base substrate;
   a step of embedding for embedding the laminated capacitor in the first resin insulating layer;
   a step of through-hole forming for forming in the laminated capacitor through holes penetrating the first electrodes and through holes penetrating the second electrodes;
   a step of via-conductor forming for forming the first via conductors electrically mutually connecting the first electrodes and the second via conductors electronically mutually connecting the second electrodes by filling the through holes with metal conductors; and
   a step of external-terminal forming for forming the first external terminals electrically connected to the first via conductors and the second external terminals electrically connected to the second via conductors.
15. The method of manufacturing a wiring substrate according to item 14, comprising:
   the step of laminated-capacitor forming for forming a laminated capacitor being such that the first electrode and second electrode are positioned offset in the direction of the electrode face; and
   the step of through-hole forming providing through holes penetrating the end portions of the first electrodes and concurrently providing through holes penetrating the end portions of the second electrodes.
16. The method according to item 14, comprising:
   the step of embedding the laminated capacitor being embedded in the first resin insulating layer such that the upper face of the laminated capacitor and the upper face of the resin insulating layer sit flush with each other.
17. The method according to item 14, comprising:
   a step of laminating, following the step of embedding, the second resin insulating layer on the first resin insulating layer.
18. The method according to item 17, wherein
   the through-hole forming for forming through holes not only penetrates the first electrodes or the second electrodes but also penetrates the second insulating layer; and
   the step of via-conductor forming providing via conductors electrically connects the conductor patterns on the base substrate and the conductor patterns on the second resin insulating layer.
19. The method according to item 17, comprising:
   forming, following the step of via-conductor forming, further the third resin insulating layer on the second resin insulating layer; and
   forming via conductors electrically connecting the conductor patterns on the second resin insulating layer and the conductor patterns on the third resin insulating layer.
20. The method according to item 14, wherein
   the step of embedding uses as references for aligning the laminated capacitor and the first resin insulating layer the alignment mark provided on the uppermost layer capacitor or the alignment mark provided on the lowermost layer capacitor of the laminated capacitor and the alignment mark provided on the base substrate.
21. The method according to item 16, wherein
   the step of via-conductor forming provides via conductors electrically connecting the conductor patterns on the base substrate and the conductor patterns on the first resin insulating layer.
22. The method according to item 21, comprising
   forming an electrode such that the conductor patterns on the first resin insulating layer and the first electrode of the capacitor present at the uppermost face of the laminated capacitor are integrated.
23. The method according to item 14, wherein
   the step of laminated-capacitor forming is such that the first electrode has a plurality of first opening portions and concurrently that the second electrode has a plurality of the second opening portions; and
   the step of through-hole forming provides through holes penetrating the first electrodes while penetrating the second openings without being in contact with the second electrodes and concurrently provides through holes penetrating the second electrodes while penetrating the first openings without being in contact with the first electrodes.
24. The method according to item 14, wherein
   the adhesive is a resin forming the first resin insulating layer.
25. A method of manufacturing a wiring substrate comprising:
   a step of capacitor forming for forming capacitors having a dielectric layer and the first electrode and the second electrode sandwiching the dielectric layer and mutually facing;
   a step of laminated-capacitor forming for forming a laminated capacitor by laminating the capacitors via an adhesive;
   a step of the-first-external-connection-terminal forming for forming on a support board the first external connection terminals having the first external terminals and the second external terminals;
   a step of building-up for alternately laminating on the first external connection terminals and on the support board a plurality of resin insulating layers and a plurality of conductor circuits;
   a step of embedding for embedding the laminated capacitor in one resin insulating layer of the plurality of resin insulating layers;
   a step of through-hole forming for forming through holes penetrating the first electrodes or the second electrodes in the laminated capacitor;
   a step of via-conductor forming for forming the first via conductors electrically mutually connecting the first electrodes and the second via conductors electronically mutually connecting the second electrodes by filling the through holes with metal conductors;
   a step of the second-external-connection-terminal forming for forming the second external connection terminals having the third external terminals and the fourth external terminals on the uppermost layer resin insulting layer positioned, of the plurality of resin insulating layers, on the opposite side from the support board; and
   a step of support board removal for removing the support board,
   wherein the first external terminals and the third external terminals are electrically connected to the first via conductors and the second external terminals and the fourth external terminals are electrically connected to the second via conductors.

## Claims

1. A wiring substrate comprising:
a plurality of resin insulating layers having at least a lowermost resin insulating layer and an uppermost resin insulating layer;
a plurality of conductor circuits formed in between the resin insulating layers;
a laminated capacitor embedded in one of the plurality of resin insulating layers and formed by laminating capacitors via an adhesive, the capacitor being formed of a dielectric layer and the first electrode and the second electrode sandwiching the dielectric layer and mutually facing;
first via conductors electrically connecting the first electrodes mutually;
second via conductors electrically connecting the second electrodes mutually;
first external connection terminals formed on the lowermost resin insulating layer and comprising the first external terminals electrically connected to the first via conductors and the second external terminals electrically connected to the second via conductors; and
second external connection terminals formed in the uppermost resin insulating layer and comprising the third external terminals electrically connected to the first via conductors and the fourth external terminals electrically connected to the second via conductors, wherein
the first external connection terminals are formed on the lowermost resin insulating layer and concurrently the external terminal faces of the first external connection terminals are positioned on nearly the same plane as the first face of the lowermost resin insulating layer; and
the second external connection terminals are embedded in the uppermost resin insulating layer.

2. A method of manufacturing a wiring substrate comprising:
a step of capacitor forming for forming capacitors having a dielectric layer and the first electrode and the second electrode sandwiching the dielectric layer and mutually facing;
a step of laminated-capacitor forming for forming a laminated capacitor by laminating the capacitors via an adhesive;
a step of the first-external-connection-terminal forming for forming on a support board the first external connection terminals having the first external terminals and the second external terminals;
a step of building-up for alternately laminating on the first external connection terminals and on the support board a plurality of resin insulating layers and a plurality of conductor circuits;
a step of embedding for embedding the laminated capacitor in one resin insulating layer of the plurality of resin insulating layers;
a step of through-hole forming for forming through holes penetrating the first electrodes or the second electrodes in the laminated capacitor;
a step of via-conductor forming for forming the first via conductors electrically mutually connecting the first electrodes and the second via conductors electronically mutually connecting the second electrodes by filling the through holes with metal conductors;
a step of the second-external-connection-terminal forming for forming the second external connection terminals having the third external terminals and the fourth external terminals on the uppermost layer resin insulating layer positioned, of the plurality of resin insulating layers, on the opposite side from the support board; and
a step of support board removal for removing the support board,
wherein the first external terminals and the third external terminals are electrically connected to the first via conductors and the second external terminals and the fourth external terminals are electrically connected to the second via conductors.

3. A wiring substrate comprising:
a laminated capacitor formed by laminating capacitors via an adhesive, the capacitor being formed of a dielectric layer and a first electrode and a second electrode sandwiching the dielectric layer and mutually facing;
a first resin insulating layer with the laminated capacitor built-in;
a base substrate supporting the first resin insulating layer;
first via conductors electrically connecting the first electrodes mutually;
second via conductors electrically connecting the second electrodes mutually;
first external terminals electrically connected to the first via conductors; and
second external terminals electrically connected to the second via conductors.

4. The wiring substrate according to claim 3, wherein
the first electrode and second electrode are such that they are disposed mutually offset in the direction of the faces of the electrodes;
the first via conductors penetrates the end portions of the first electrodes such that they electrically connect the first electrodes mutually; and
the second via conductors penetrates the end portions of the second electrodes such that they electrically connect the second electrodes mutually.

5. The wiring substrate according to claim 3, wherein the upper face of the laminated capacitor is at the upper face of the first resin insulating layer and the upper face of the laminated capacitor and the upper face of the first resin insulating layer are flush with each other.

6. The wiring substrate according to claim 3, further comprising:
a second resin insulating layer being on the first resin insulating layer.

7. The wiring substrate according to claim 6, wherein:
conductor patterns are provided on the base substrate and on the second resin insulating layer; and
the via conductors electrically connect the conductor patterns on the base substrate and the conductor patterns on the second resin insulating layer.

8. The wiring substrate according to claim 6, further comprising:
a third resin insulating layer being on the second resin insulating layer.

9. The wiring substrate according to claim 8, comprising:
conductor patterns on the second resin insulating layer;
conductor patterns on the third resin insulating layer; and preferably comprising:
via conductors electrically connecting the conductor patterns on the second resin insulating layer and the conductor patterns on the third resin insulating layer.

10. The wiring substrate according to claim 5, comprising:
conductor patterns being provided on the base substrate and on the first resin insulating layer, wherein
the via conductors electrically connecting the conductor patterns on the base substrate and the conductor patterns on the first resin insulating layer,
wherein, preferably, the conductor patterns on the first resin insulating layer and the first electrode of the capacitor present at the uppermost face of the laminated capacitor are integrated such that they form an electrode.

11. The wiring substrate according to claim 3, wherein
the first electrodes have a plurality of the first opening portions;
the second electrodes have a plurality of the second opening portions;
the first via conductors electrically connect the first electrodes mutually while running through the second opening portions without being in contact with the second electrodes; and
the second via conductors electrically connect the second electrodes mutually while running through the first opening portions without being in contact with the first electrodes.

12. A method of manufacturing a wiring substrate comprising:
a step of capacitor forming for forming the capacitors having a dielectric layer and the first electrode and the second electrode mutually opposing with the dielectric layer being sandwiched therebetween;
a step of laminated-capacitor forming for forming a laminated capacitor by laminating the capacitors via an adhesive;
a step of laminating for laminating the first resin insulating layer on a base substrate;
a step of embedding for embedding the laminated capacitor in the first resin insulating layer;
a step of through-hole forming for forming in the laminated capacitor through holes penetrating the first electrodes and through holes penetrating the second electrodes;
a step of via-conductor forming for forming the first via conductors electrically mutually connecting the first electrodes and the second via conductors electronically mutually connecting the second electrodes by filling the through holes with metal conductors; and
a step of external-terminal forming for forming the first external terminals electrically connected to the first via conductors and the second external terminals electrically connected to the second via conductors.

13. The method of manufacturing a wiring substrate according to claim 12, comprising:
the step of laminated-capacitor forming for forming a laminated capacitor being such that the first electrode and second electrode are positioned offset in the direction of the electrode face; and
the step of through-hole forming providing through holes penetrating the end portions of the first electrodes and concurrently providing through holes penetrating the end portions of the second electrodes.

14. The method according to claim 13, comprising:
the step of embedding the laminated capacitor being embedded in the first resin insulating layer such that the upper face of the laminated capacitor and the upper face of the resin insulating layer sit flush with each other.

15. The method according to claim 12, comprising:
a step of laminating, following the step of embedding, the second resin insulating layer on the first resin insulating layer.
